(19) Europäisches Patentamt / European Patent Office / Office européen des brevets

(11) **EP 4 058 816 B1**

(12) **EUROPÄISCHE PATENTSCHRIFT**

(45) Veröffentlichungstag und Bekanntmachung des Hinweises auf die Patenterteilung:
**26.02.2025 Patentblatt 2025/09**

(21) Anmeldenummer: **20803179.9**

(22) Anmeldetag: **12.11.2020**

(51) Internationale Patentklassifikation (IPC):
**G01R 31/327** (2006.01)

(52) Gemeinsame Patentklassifikation (CPC):
**G01R 31/3271; G01R 31/3275**

(86) Internationale Anmeldenummer:
**PCT/EP2020/081847**

(87) Internationale Veröffentlichungsnummer:
**WO 2021/094418 (20.05.2021 Gazette 2021/20)**

(54) **KONTAKTÜBERWACHUNGSVORRICHTUNG**

CONTACT-MONITORING DEVICE

DISPOSITIF DE SURVEILLANCE DE CONTACT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.11.2019 DE 102019130646**
**03.04.2020 BE 202005218**

(43) Veröffentlichungstag der Anmeldung:
**21.09.2022 Patentblatt 2022/38**

(73) Patentinhaber: **Phoenix Contact GmbH & Co. KG**
**32825 Blomberg (DE)**

(72) Erfinder:
• **SCHOLZ, Peter**
**33034 Brakel (DE)**
• **FISCHER, Marius**
**33098 Paderborn (DE)**
• **REINHOLD, Christian**
**31785 Hameln (DE)**

(74) Vertreter: **LifeTech IP**
**Spies & Behrndt Patentanwälte PartG mbB**
**Elsenheimerstraße 47a**
**80687 München (DE)**

(56) Entgegenhaltungen:
WO-A1-2018/059649    WO-A1-2019/238403
DE-A1- 102009 006 970    JP-A- 2012 211 855

**Beschreibung**

Die vorliegende Offenbarung betrifft eine Kontaktüberwachungsvorrichtung zur Überwachung eines elektrischen Kontaktes, insbesondere zur Überwachung eines Schaltvorgangs eines Schaltkontakts, eines Funktionszustandes einer Überstromsicherung und/oder eines Funktionszustandes einer Überspannungssicherung.

In der elektrischen Automation können Aktoren mit einem Schalter geschaltet werden, wobei es notwendig sein kann, ein tatsächliches Durchschalten eines Schaltkontakts des Schalters zu erfassen. Eine solche überwachte Rückmeldung kann beispielsweise mittels zusätzlicher Hilfskontakte realisiert sein. Alternativ kann zum Unterbinden einer Fehlschaltung des Schalters unter erhöhtem Produktionskostenaufwand eine Kontaktzwangsführung realisiert sein. Ein fehlerhafter Schaltkontakt kann beispielsweise defekte, insbesondere verschweißte Schaltflächen oder degradierte Halbleiterschichten aufweisen, sodass ein Ab- oder Anschalten entgegen einem anliegenden Anschaltsignal oder entgegen einer mechanischen Betätigung nicht realisiert werden kann.

Die Überwachung von Schaltkontakten ist insbesondere für Maschinen- und Anlagensteuerungen erforderlich, wo z.B. Schaltrelais eingesetzt werden, deren Schaltkontakte häufig geschaltet werden. Solche Kontakte unterliegen stärkerem Verschleiß. Relais können so ausgelegt werden, dass die Schaltkontakte z.B. mehrere 100.000 Schaltvorgänge aushalten können. Mit der Kontaktüberwachungsvorrichtung ist es möglich, den Zustand des Kontaktes zu überwachen und bei den ersten Anzeichen des erhöhten Verschleißes eine Meldung auszugeben, mit der auf den Verschleißzustand hingewiesen wird. Das Betriebspersonal kann dann den Kontakt z.B. in Form des Relais frühzeitig austauschen.

Solche Kontaktüberwachungsvorrichtungen sind im Prinzip bekannt, z. B. beschreibt das Dokument DE 10 2009 006 970 A1 ein Verfahren und eine Schaltung zur Funktionsprüfung für eine Halbleitervorrichtung bestimmt. Sie arbeiten aber oft auf Basis eines Schwingkreises, der durch den Schaltkontakt beeinflusst wird. In einem Schaltzustand liegt eine geringe Dämpfung an dem Schwingkreis an und in dem anderen Schaltzustand eine höhere Dämpfung. So ändert sich mindestens die Amplitude der Schwingung, was z.B. über einen Spannungsabfall an einem Widerstand gemessen werden kann.

Die DE 10 2018 114 425 A1 zeigt ein konkretes Beispiel dieser Art einer Kontaktüberwachungsvorrichtung. Dort wird die Kontaktüberwachungsvorrichtung am Beispiel der Überwachung eines Relaisschaltkontaktes beschrieben. Ein Schwingkreis wird von einem Signalgenerator über einen Übertrager mit einem Anregungssignal gespeist. Schwingkreise können allerdings temperaturabhängige Eigenschaften aufweisen, was zu Problemen mit der Zuverlässigkeit der Messung der Amplitudenänderung führen kann.

Eine Lösung für einen temperaturkompensierten Schwingkreis ist aus der JP 2012 211 855 A bekannt. Dort dient ein FET-Transistor zur Einstellung der Resonanzfrequenz des Schwingkreises, dessen Arbeitspunkt über den Einsatz eines Thermistors in dem Spannungsteiler zur Einstellung des Arbeitspunktes temperaturkompensiert wird. Der temperaturkompensierte Oszillator wird bei einem RADAR-Sensor für ein Fahrzeug eingesetzt. Der FET-Transistor des Oszillators wird dort auch als frequenzbestimmendes Element eingesetzt, denn es sind die Transistorkapazitäten, die mit der Spule zusammen den Schwingkreis bilden. Bei Verstellung des Arbeitspunktes ändern sich die Transistorkapazitäten und damit auch die Resonanzfrequenz.

Die bekannten Lösungen für eine Kontaktüberwachungsschaltung haben allerdings den Nachteil, dass sie nicht zuverlässig genug zwischen der ordnungsgemäßen Funktion des Kontakts und einem Fehlverhalten unterscheiden können oder dafür einen komplexen Aufbau benötigen und somit aufwändig und teuer sein können. Zusätzlich besteht ein Problem mit einer Temperaturabhängigkeit der bestehenden Kontaktüberwachungsvorrichtungen. Es besteht deshalb der Bedarf für eine verbesserte Kontaktüberwachungsvorrichtung, bei der insbesondere die Zuverlässigkeit der Kontaktüberwachung verbessert ist und die nur wenige und kostengünstige Komponenten benötigt. Dies wurde im Rahmen der Erfindung erkannt.

Diese Aufgabe wird durch die Merkmale des unabhängigen Anspruchs 1 gelöst. Vorteilhafte Ausführungsformen sind Gegenstand der abhängigen Ansprüche, der Beschreibung sowie der beiliegenden Figuren.

Die vorliegende Offenbarung basiert auf der Erkenntnis, dass die obige Aufgabe durch eine Kontaktüberwachungsvorrichtung gemäß Anspruch 1 gelöst werden kann, welche ausgebildet ist, an dem elektrischen Kontakt mittels eines Oszillatorschaltkreises und, dem Oszillatorschaltkreis nachgeschalteten, Koppelelement und Dämpfungselement, insbesondere in einem geschlossenen Kontaktzustand des elektrischen Kontakts, ein Kontaktüberwachungssignal zu generieren. In einer Ausprägung ist der Oszillatorschaltkreis mit dem elektrischen Kontakt in einem geöffneten Kontaktzustand nicht schwingungsfähig, sodass das Kontaktüberwachungssignals nicht erzeugt wird.

In einer anderen Ausprägung ist der Oszillatorschaltkreis auch in dem geöffneten Kontaktzustand schwingungsfähig, allerdings mit einer anderen Resonanzfrequenz. Dies kann dadurch erreicht werden, dass bei Umschalten des Kontakts z.B. eine weitere Kapazität in dem Schwingkreis zugeschaltet wird, sodass eine andere Gesamtkapazität in dem LC-Schwingkreis wirkt. Ist der Kontakt defekt, schließt er bei dem Schaltvorgang nicht mehr richtig und es wird keine Resonanzschwingung mehr ausgeführt oder aber es wird die andere Resonanzschwingung nicht mehr ausgeführt. Dies wird detektiert und entsprechend zur Anzeige gebracht.

Bei einer allgemeinen Ausführung wird mit dem elektrischen Kontakt in dem ersten Kontaktzustand an dem Oszillatorschaltkreis ein erstes Dämpfungselement wirksam geschaltet, das einen ersten Impedanzverlauf bei dem Oszillatorschaltkreis bewirkt und mit dem elektrischen Kontakt in dem zweiten Kontaktzustand an dem Oszillatorschaltkreis das erste Dämpfungselement unwirksam geschaltet wird und/oder ein zweites Dämpfungselement wirksam geschaltet wird, das einen zweiten Impedanzverlauf des Oszillatorschaltkreis bewirkt, wobei der Oszillatorschaltkreis ausgebildet ist, mit dem elektrischen Kontakt in dem ersten Kontaktzustand und dem ersten Impedanzverlauf eine Resonanzschwingung zu erzeugen und das Anregungssignal auszugeben; und mit dem elektrischen Kontakt in dem zweiten Kontaktzustand und dem zweiten Impedanzverlauf entweder keine Resonanzschwingung zu erzeugen und kein Anregungssignal auszugeben oder eine andere Resonanzschwingung zu erzeugen und ein anderes Anregungssignal auszugeben; wobei der Detektor ausgebildet ist, das eine Anregungssignal und das andere Anregungssignal oder kein Anregungssignal zu erfassen, um den elektrischen Kontakt zu überwachen. Die andere Resonanzschwingung wird erzeugt, wenn durch den Wechsel des Kontaktzustandes ein anderes frequenzbestimmendes Element in dem Oszillatorschaltkreis wirksam geschaltet wird.

Ferner wird in dem Oszillatorschaltkreis ein Mittel zur thermischen Stabilisierung des Oszillatorschaltkreises vorgesehen. Dabei weist der Oszillatorschaltkreis einen Schwingkreis mit einem Rückkopplungszweig auf und einen Verstärker, wobei der Verstärker das über den Rückkopplungszweig rückgekoppelte Signal verstärkt.

Die Lösung sieht dann vor, dass der Verstärker wenigstens einen Transistor aufweist, dessen Verstärkung durch seinen Arbeitspunkt einstellbar ist, wobei die Verstärkung des wenigstens einen Transistors mit dem Mittel zur thermischen Stabilisierung stabilisiert ist. Dies geschieht so, dass der Arbeitspunkt des Transistors verschoben wird, durch die Veränderung des Mittels zur thermischen Stabilisierung bei Temperaturänderung. Dadurch wird die Verstärkung des Transistors automatisch konstant gehalten, auch wenn sich die Temperatur ändert.

In einer bevorzugten Variante, wird als Mittel zur thermischen Stabilisierung ein Thermistor, insbesondere ein NTC- oder PTC-Widerstand als ein Element eines Spannungsteilers eingesetzt. Der NTC-Widerstand entspricht einem Heißleiter und der PTC-Widerstand einem Kaltleiter. Alternativ kann als Heißleiter auch eine Halbleiterdiode eingesetzt werden, die in Sperrrichtung geschaltet wird. Durch die Veränderung des Widerstandes des Thermistors wird der Arbeitspunkt des Transistors verschoben, und dadurch der Verstärkungsfaktor stabil gehalten.

In einer anderen Ausführungsform wird als Mittel zur thermischen Stabilisierung ein Temperatursensor eingesetzt, dessen Signal von einem Mikrocontroller ausgewertet wird, der ein zugehöriges Korrektursignal erzeugt, das den Arbeitspunkt des wenigstens einen Transistors zur thermischen Stabilisierung einstellt.

Dabei kann der Mikrocontroller das Korrektursignal in Form eines PWM-Signals, entsprechend pulsweitenmoduliertes Signal, erzeugen, und ein Mittelwertbilder eingesetzt werden, der den Mittelwert des PWM-Signal je nach Tastgrad ausgibt. Mit dem gemittelten Korrektursignal wird der Arbeitspunkt eingestellt.

In einer kostengünstigen Variante wird der Mittelwertbilder in Form eines Tiefpassfilters bestehend aus einem Widerstand und einem Kondensator ausgebildet.

Diese Form der thermischen Stabilisierung hat den Vorteil, dass die Temperaturkompensation sehr genau ausgeführt werden kann. Allerdings sind die Kosten für diese Lösung höher.

Das Kontaktüberwachungssignal kann insbesondere eine hochfrequente Hilfsenergie sein, welche von dem Oszillatorschaltkreis erzeugt und durch das Koppelelement in den Lastschaltkreis mit dem elektrischen Kontakt eingekoppelt wird. Eine Änderung der Impedanz des Lastschaltkreises, insbesondere durch ein Schalten des elektrischen Kontakts wird über das Koppelelement zu dem Oszillatorschaltkreis rückgekoppelt und erzeugt eine Signaländerung zwischen dem Oszillatorschaltkreis und dem Koppelelement, welche genutzt werden kann, um ein Schalten des elektrischen Kontakts zu erfassen.

Gemäß einem ersten Aspekt betrifft die Offenbarung eine Kontaktüberwachungsvorrichtung zur Überwachung eines elektrischen Kontakts mit einem ersten Kontaktzustand und einem zweiten Kontaktzustand. Insbesondere kann der elektrische Kontakt ein Schaltkontakt sein, welcher in dem ersten Kontaktzustand geschlossen ist und in dem zweiten Kontaktzustand geöffnet ist. Beispielsweise kann der elektrische Kontakt in dem ersten Kontaktzustand niederohmig sein und in dem zweiten Kontaktzustand hochohmig sein.

Die Kontaktüberwachungsvorrichtung umfasst einen Oszillatorschaltkreis, welcher ausgebildet ist, ein Anregungssignal zu erzeugen, und ein Koppelelement mit einem Signaleingang und einem Signalausgang. Der Oszillatorschaltkreis ist dem Signaleingang vorgeschaltet, um das Koppelelement mit dem Anregungssignal zu beaufschlagen, und das Koppelelement ist ausgebildet, das Anregungssignal in ein Kontaktüberwachungssignal zu überführen und das Kontaktüberwachungssignal an dem Signalausgang zum Beaufschlagen des elektrischen Kontaktes auszugeben.

Mit dem elektrischen Kontakt in dem ersten Kontaktzustand ist an dem Oszillatorschaltkreis ein erster Impedanzwert eingestellt, und mit dem elektrischen Kontakt in dem zweiten Kontaktzustand ist an dem Oszillatorschaltkreis ein zweiter Impedanzwert eingestellt. Der Oszillatorschaltkreis ist ausgebildet, mit dem elektrischen Kontakt in dem ersten Kontaktzustand und mit dem ersten Impedanzwert eine Resonanzschwingung zu erzeugen und eine Version des Anregungssignals, beispielsweise ein in der Amplitude verändertes, insbesondere gedämpftes, Anregungssignal auszugeben.

In einer Ausführungsform wird mit dem elektrischen Kontakt in dem zweiten Kontaktzustand und mit dem zweiten Impedanzwert eine Ausgabe des Anregungssignals unterbunden.

Ferner umfasst die Kontaktüberwachungsvorrichtung einen Detektor, welcher ausgebildet ist, eine Version des Anregungssignals und/oder eine Änderung des Anregungssignals zu erfassen, um den elektrischen Kontakt zu überwachen.

Der erste Impedanzwert kann insbesondere größer sein als der zweite Impedanzwert. Ferner kann ein Dämpfungselement vorgesehen sein, den ersten Impedanzwert und/oder den zweiten Impedanzwert, insbesondere in Abhängigkeit von dem jeweiligen Kontaktzustand des elektrischen Kontakts, an dem Signaleingang einzustellen.

Der elektrische Kontakt kann in dem ersten Kontaktzustand elektrisch leitend sein und in dem zweiten Kontaktzustand elektrisch nichtleitend sein. Insbesondere kann die Kontaktüberwachungsvorrichtung ausgebildet sein, das Kontaktüberwachungssignal nicht kontinuierlich an den elektrischen Kontakt anzulegen, um ein dauerhaftes Einkoppeln eines, insbesondere hochfrequenten, Kontaktüberwachungssignals über den elektrischen Kontakt in einen Lastschaltkreis, welcher insbesondere niederfrequente Signale leitet, zu unterbinden. Entsprechend kann der Vorteil verbesserter EMV-Eigenschaften der Kontaktüberwachungsvorrichtung erreicht werden.

Der elektrische Kontakt kann ein Leistungsschaltkontakt eines elektromechanischen Relais, eines Halbleiterrelais, eines Schützes, eines Reed-Kontaktes oder eines mechanischen Schalters sein. Der elektrische Kontakt kann insbesondere ausgebildet sein, in einem ersten, insbesondere geschlossenen Kontaktzustand einen ersten ohmschen Widerstand aufzuweisen und in einem zweiten, insbesondere geöffneten Kontaktzustand einen zweiten ohmschen Widerstand aufzuweisen, wobei der erste ohmsche Widerstand kleiner ist als der zweite ohmsche Widerstand. Insbesondere ist der elektrische Kontakt in dem geschlossenen Kontaktzustand niederohmig und in dem geöffneten Kontaktzustand hochohmig.

Der elektrische Kontakt kann eine Sicherung sein, insbesondere eine Schmelzsicherung, welche in einem ersten Kontaktzustand elektrisch leitend, respektive niederohmig ist und in einem zweiten Kontaktzustand, in welchem die Sicherung ausgelöst hat, elektrisch nichtleitend, respektive hochohmig ist.

Ferner kann der erste Kontaktzustand ein erster Schaltzustand des elektrischen Kontaktes, insbesondere eines elektrischen Schaltelements sein und der zweite Kontaktzustand kann ein zweiter Schaltzustand des elektrischen Kontaktes, insbesondere des elektrischen Schaltelements sein.

In einer Ausführungsform ist die Kontaktüberwachungsvorrichtung ausgebildet, das Kontaktüberwachungssignal als ein differentielles Signal an den elektrischen Kontakt anzulegen, wobei das differentielle Signal ein Stromsignal ist, welches an einem kleinen Kontaktwiderstand, insbesondere dem elektrischen Kontakt in dem ersten Kontaktzustand, einen geringen Spannungsabfall verursacht. Dadurch wird insbesondere der Vorteil erreicht, dass das Kontaktüberwachungssignal in dem elektrischen Kontakt eine geringe Amplitude aufweist und entsprechend nur geringe hochfrequente Signalanteile mit einem über den elektrischen Kontakt fließenden Nutzsignal überlagert sind. Entsprechend können die EMV-Eigenschaften der Kontaktüberwachungsvorrichtung verbessert sein.

In einer Ausführungsform ist der Oszillatorschaltkreis ausgebildet, das Anregungssignal im Hochfrequenzbereich zu erzeugen, vorzugsweise mit einer Frequenz in einem Bereich von 1 MHz bis 100 MHz, weiter bevorzugt mit einer Frequenz von 50 MHz. Dadurch kann insbesondere der Vorteil erreicht werden, dass eine Frequenztrennung des Kontaktüberwachungssignals und des Nutzsignals durch kostengünstige Frequenzfilterelemente realisiert werden kann. Der Oszillatorschaltkreis kann ein Hochfrequenzgenerator sein, welcher insbesondere über das Koppelelement und das Dämpfungselement, beispielsweise parallel, an den elektrischen Kontakt angeschaltet ist.

In einer Ausführungsform umfasst der Oszillatorschaltkreis einen selbstschwingenden Oszillator, welcher insbesondere eine variable Resonanzfrequenz aufweist und ausgebildet ist, mit dem elektrischen Kontakt in einem ersten Kontaktzustand, insbesondere einem niederohmigen, geschlossenen Kontaktzustand eine elektromagnetische Schwingung zu erzeugen.

In einer Ausführungsform ist das Dämpfungselement ausgebildet, mit dem zweiten Kontaktzustand den ersten Impedanzwert an dem Signaleingang einzustellen. Entsprechend kann der Oszillatorschaltkreis ausgebildet sein, mit dem geöffneten elektrischen Kontakt das Anregungssignal zu erzeugen, respektive mit dem geschlossenen elektrischen Kontakt das Anregungssignal nicht zu erzeugen.

Mit dem Überwachen des elektrischen Kontakts eines Relais durch die Kontaktüberwachungsvorrichtung kann bei einem Beaufschlagen des elektrischen Kontakts mit dem Anschaltsignal eine Schaltinformation bezüglich des Übergangs des elektrischen Kontakts zwischen einem ersten Kontaktzustand, in welchem der elektrische Kontakt elektrisch nichtleitend ist und einem zweiten Kontaktzustand, in welchem der elektrische Kontakt elektrisch leitend ist, generiert werden. Dadurch kann sichergestellt sein, dass das Relais mit dem Anschaltsignal schaltet und entsprechend ein Fehler an dem elektrischen Kontakt und/oder einem Magnetsystem des Relais nicht vorliegt. Entsprechend kann bei einem Anliegen des Anschaltsignals an dem Relais und einem Ausbleiben eines Schaltens des elektrischen Kontakts eine Fehlfunktion des Relais festgestellt werden. Ferner kann auch ein Abschalten des Relais mit einem Abfallen des Anschaltsignals überwacht werden.

Die Kontaktüberwachungsvorrichtung erreicht den Vorteil, dass unter dem Aspekt der funktionalen Sicherheit, insbesondere nach der Norm IEC 61508 ein eindeutiges Erfassen des Kontaktzustands des Relaisschaltkontakts realisiert werden kann. Entsprechend kann ein erhöhter Diagnosedeckungsgrad erreicht werden.

Der Detektor kann insbesondere ausgebildet sein, eine Änderung des Anregungssignals respektive eine Änderung des Kontaktüberwachungssignals in ein Ausgabesignal zu wandeln, welches ein zeit-diskretes und/oder amplitudendiskretes Signal, insbesondere ein binäres Signal und/oder ein digitales Signal sein kann. Eine erste Ausgabesignalamplitude kann dem ersten Kontaktzustand, respektive einem geschlossenen elektrischen Kontakt, zugeordnet sein und eine zweite Ausgabesignalamplitude kann dem zweiten Kontaktzustand, respektive einem geöffneten elektrischen Kontakt, zugeordnet sein. Der Detektor kann ausgebildet sein, das Ausgabesignal oder dessen Version instantan oder mit einer möglichst kleinen Zeitverzögerung an eine Änderung des Anregungssignals und/oder des Kontaktüberwachungssignals anzupassen. Eine Änderung des Anregungssignals kann insbesondere ein Wechsel zwischen dem Erzeugen des Anregungssignals auf Basis einer erfüllten Resonanzbedingung des Oszillatorschaltkreises und dem Nichterzeugen des Anregungssignals auf Basis einer nichterfüllten Resonanzbedingung des Oszillatorschaltkreises sein.

In einer Ausführungsform ist in dem zweiten Kontaktzustand die Ausbildung der Resonanzschwingung unterbunden, wodurch die Ausgabe des Anregungssignals unterbunden wird.

In einer Ausführungsform ist der Oszillatorschaltkreis ausgebildet, mit dem ersten Impedanzwert das Anregungssignal mit einer Anregungsfrequenz, welcher einer Resonanzfrequenz des Oszillatorschaltkreises entspricht, zu erzeugen, wobei der Oszillatorschaltkreis ferner ausgebildet ist, eine Signalamplitude des Anregungssignals auf Basis eines Impedanzwertes an dem Signaleingang zu ändern. Der Oszillatorschaltkreis kann ausgebildet sein, mit einer Änderung des Impedanzwerts an dem Signaleingang von einem nicht schwingungsfähigen Zustand in einen schwingungsfähigen Zustand zu wechseln, wobei mit einer stetigen Impedanzwertänderung auch die Signalamplitude des Anregungssignals stetig geändert werden kann. Der Oszillatorschaltkreis ist ferner ausgebildet, mit einer Überschreitung eines Impedanzgrenzwerts an dem Signaleingang von dem nichtschwingungsfähigen Zustand in den schwingungsfähigen Zustand überzugehen.

In einer Ausführungsform umfasst die Kontaktüberwachungsvorrichtung ein Dämpfungselement, welches dem Signalausgang nachgeschaltet und mit dem elektrischen Kontakt gekoppelt, beispielsweise vorgeschaltet oder nachgeschaltet ist, wobei das Dämpfungselement ausgebildet ist, mit dem elektrischen Kontakt in dem zweiten Kontaktzustand eine Impedanz bereitzustellen, um ein Wirken einer Impedanz des elektrischen Kontakts in dem zweiten Kontaktzustand zu unterbinden, wobei mit dem Wirken des Dämpfungselements der Signaleingang des Koppelelements gedämpft ist, der Oszillatorschaltkreis nicht schwingungsfähig ist und eine Ausgabe des Anregungssignals unterbunden ist.

In einer Ausführungsform sind das Koppelelement und der Oszillatorschaltkreis ausgebildet, einen Schwingkreis zu bilden, wobei das Dämpfungselement ausgebildet ist, den Schwingkreis in dem zweiten Kontaktzustand zu dämpfen, um eine Signalamplitude des Anregungssignals zu reduzieren.

In einer Ausführungsform ist das Dämpfungselement mit dem elektrischen Kontakt gekoppelt, beispielsweise elektrisch parallelgeschaltet, wobei mit dem elektrischen Kontakt in dem ersten Kontaktzustand das Dämpfungselement niederohmig überbrückt ist und eine mittels des Kopplungselements an den Signaleingang gekoppelte Dämpfung des Dämpfungselements reduziert ist. Der Oszillatorschaltkreis ist ausgebildet, mit der reduzierten Dämpfung das Anregungssignal mit einer erhöhten Signalamplitude zu erzeugen.

In einer Ausführungsform weist der Oszillatorschaltkreis einen Detektorausgang auf und ist ausgebildet, über den Detektorausgang dem Detektor das Anregungssignal bzw. eine Version des Anregungssignals bereitzustellen.

In einer Ausführungsform ist der Detektor ausgebildet, das Anregungssignal in ein Ausgabesignal zu wandeln und das Ausgabesignal in mindestens zwei unterschiedlichen Signalzuständen auszugeben, wobei ein erster Signalzustand der mindestens zwei Signalzustände einen geschlossenen elektrischen Kontakt anzeigt und ein zweiter Signalzustand der mindestens zwei Signalzustände einen offenen elektrischen Kontakt anzeigt.

In einer Ausführungsform ist der Detektor ausgebildet, das Ausgabesignal in dem ersten Signalzustand auszugeben, wenn an dem Detektorausgang ein oszillierendes Anregungssignal anliegt und das Ausgabesignal in dem zweiten Signalzustand auszugeben, wenn an dem Detektorausgang ein nicht-oszillierendes Anregungssignal anliegt, eine Signalamplitude des Anregungssignals unterhalb eines Amplitudengrenzwerts liegt und/oder das Anregungssignal nicht an dem Detektorausgang nicht anliegt.

In einer Ausführungsform ist das Koppelelement ausgebildet, den Oszillatorschaltkreis und/oder den Detektor von dem elektrischen Kontakt galvanisch zu trennen.

In einer Ausführungsform ist das Koppelelement als eine direkte galvanische Anbindung, beispielsweise als eine Kabelverbindung, des Kontaktes an den Oszillatorschaltkreis ausgebildet, sodass eine Änderung des elektrischen Kontaktes direkt auf die Impedanz des Oszillatorkreises wirken kann.

In einer Ausführungsform ist der Detektor ausgebildet, ein Anschaltsignal zum Schalten des elektrischen Kontakts und eine Änderung des Anregungssignals zu erfassen und ein binäres Fehlersignal auszugeben, welches anzeigt, ob der elektrischen Kontakt entsprechend dem Anschaltsignal geschaltet ist. Dadurch kann der Vorteil erreicht werden, dass der Detektor erfassen kann, ob sowohl das Anschaltsignal als auch das Anregungssignal eine identische logische Information über den Kontaktzustand des elektrischen Kontakts tragen. Dem Detektor kann insbesondere über einen Schaltsteueranschluss das Anschaltsignal bereitgestellt sein.

Der Detektor kann ferner ausgebildet sein, mit dem Anliegen des Anregungssignals respektive einer Resonanzschwingung an dem Detektoreingang eine erste logische Information zu erfassen und mit dem Anliegen des Anschaltsignals an dem Schaltsteueranschluss das Anregungssignal mit dem Anschaltsignal eine zweite logische Information zu erfassen. Weiterhin kann der Detektor ausgebildet sein, die erste logische Information mit der zweiten logischen Information zu vergleichen.

Der Detektor kann ausgebildet sein, auf Basis des Vergleichs der ersten logischen Information mit der zweiten logischen Information ein Ausgabesignal zu erzeugen, wobei das Ausgabesignal eine Übereinstimmung oder eine Divergenz der ersten logischen Information in Bezug auf die zweite logische Information anzeigt. Die erste logische Information kann insbesondere eine binäre Schaltinformation in Bezug auf den elektrischen Kontakt sein, welche ein Schalten des elektrischen Kontakts auslösen soll und die zweite logische Information kann insbesondere eine binäre Prüfinformation sein, welche den Kontaktzustand des elektrischen Kontakts beschreibt. Insbesondere kann die binäre Prüfinformation in Bezug auf die elektrische Leitfähigkeit des elektrischen Kontakts informieren.

Mit der binären Schaltinformation und der binären Prüfinformation sind vier unterschiedliche Signalkombinationen realisierbar (siehe Tabelle 1).

Tabelle 1: Mögliche Kombinationen Schaltinformation und Prüfinformation

| Index | Schaltinformation 0: Kontakt öffnen 1: Kontakt schließen | Prüfinformation 0: elektrischer Kontakt offen 1: elektrischer Kontakt geschlossen | Zustand / Beschreibung |
|---|---|---|---|
| 1 | 0 | 0 | Ordnungsgemäßer Betrieb, elektrischer Kontakt offen |
| 2 | 0 | 1 | Fehlerzustand, |
| 3 | 1 | 0 | Fehlerzustand |
| 4 | 1 | 1 | Ordnungsgemäßer Betrieb, elektrischer Kontakt geschlossen |

Entsprechend den Signalkombinationen kann der Detektor ausgebildet sein, in den Fällen 1 und 4 ein Ausgabesignal mit einem Signalpegel zu erzeugen, welcher eine logische 0 repräsentiert und in den Fällen 2 und 3 ein Ausgabesignal mit einem Signalpegel zu erzeugen, welche eine logische 1 repräsentiert. Alternativ könnten die unterschiedlichen Signalkombinationen entsprechenden Amplitudenwerten oder Ausgabesignalmustern des Ausgabesignals zugeordnet werden. Ein Ausgabesignalmuster kann beispielsweise durch eine eindeutige Folge von Signalpulsen, insbesondere von Signalpulsen mit unterschiedlicher Pulslänge realisiert sein.

In einer Ausführungsform ist der Detektor ausgebildet, mit dem Empfangen des Anschaltsignals das Anregungssignal innerhalb eines vorbestimmten Zeitintervalls zu erfassen, um festzustellen, ob der elektrische Kontakt entsprechend dem Anschaltsignal innerhalb des vorbestimmten Zeitintervalls geschaltet ist.

In einer Ausführungsform umfasst die Kontaktüberwachungsvorrichtung ein optisches Anzeigeelement, welches ausgebildet ist, das Erfassen des Anschaltsignals und ein entsprechendes erfasstes Schalten des elektrischen Kontakts respektive eine Abweichung von dem erwarteten Anschaltsignal anzuzeigen.

In einer Ausführungsform umfasst das Koppelelement einen Transformator, welcher eine erste Induktivität und eine zweite Induktivität aufweist, wobei die erste Induktivität mit der zweiten Induktivität induktiv gekoppelt ist, um das Anregungssignal in das Kontaktüberwachungssignal zu überführen.

In einer Ausführungsform umfasst das Koppelement einen Transformator, welcher eine erste Luftspule und eine zweite Luftspule umfasst, welche induktiv miteinander gekoppelt sind. Die erste Luftspule und die zweite Luftspule können Zylinderspulen oder Kreisringspulen sein. Ferner kann innerhalb der ersten Luftspule und/oder innerhalb der zweiten Luftspule jeweils ein Spulenkern, insbesondere ein Ferritkern oder ein Magnetkern, angeordnet sein. In einer Ausführungsform, kann ein Magnetkern teilweise in der ersten Luftspule und/oder in der zweiten Luftspule angeordnet sein. Der Spulenkern kann aus flussführenden Ferritplatten oder Ferritfolien gebildet sein.

Der Transformator mit der ersten Induktivität und der zweiten Induktivität, welche insbesondere jeweils als Luftspulen ausgebildet sind, erreicht beispielsweise den Vorteil, dass die Spulen mittels Leiterplattentechnologie herstellbar sein können und entsprechend bei einer Herstellung der Kontaktüberwachungsvorrichtung eine Anzahl von diskreten elektronischen Bauteilen reduziert sein kann. Ferner können auch kapazitive Elemente der Kontaktüberwachungsvorrichtung als Leiterplattenkondensatoren ausgebildet sein, um die Anzahl von diskreten elektronischen Bauteilen weiter zu reduzieren.

Mit der Ausführung von Induktivitäten des Transformators als Planarspulen kann insbesondere der Vorteil einer kosteneffizienten Herstellung der Kontaktüberwachungsvorrichtung erreicht werden, da insbesondere auf ein Durchsetzen der Induktivitäten mit Ferritplatten verzichtet werden kann. Der Transformator kann insbesondere ausgebildet sein, bezüglich eines Einkoppelns des Anregungssignals über die erste Induktivität in die zweite Induktivität einen Kopplungsfaktor größer 20 % zu erreichen, um das Anregungssignal effizient in das Kontaktüberwachungssignal zu überführen.

In einer Ausführungsform umfasst die Kontaktüberwachungsvorrichtung eine Impedanzschaltung, welche dem Signalausgang nachgeschaltet und mit dem Dämpfungselement gekoppelt, beispielsweise vorgeschaltet, ist, wobei die Impedanzschaltung ausgebildet ist, eine Streuinduktivität und/oder eine Streukapazität des Koppelelements bei einem Kontaktüberwachungssignal mit einer vorbestimmten Frequenz zu kompensieren.

In einer Ausführungsform ist die Impedanzschaltung ausgebildet, eine Gesamtkapazität und/oder eine Gesamtinduktivität über der galvanischen Trennung des Koppelelements zu minimieren.

In einer Ausführungsform umfasst die Kontaktüberwachungsvorrichtung ein erstes Filterelement und ein zweites Filterelement, wobei der elektrische Kontakt einen ersten Ausgangsanschluss, welchem das erste Filterelement nachgeschaltet ist, und einen zweiten Ausgangsanschluss aufweist, welchem das zweite Filterelement nachgeschaltet ist, um hochfrequente Signale zu dämpfen, welche mittels des Koppelelements an dem elektrischen Kontakt und/oder an einer an den elektrischen Kontakt gekoppelten elektrischen Last und/oder Spannungsquelle anliegen.

Die Filterelemente erreichen insbesondere den Vorteil, die Kontaktüberwachungsvorrichtung von einer externen Beschaltung des elektrischen Kontakts, welche beispielsweise an einem ersten Ausgangsanschluss und einem zweiten Ausgangsanschluss angeschaltet ist, funktional abzutrennen. Das erste Filterelement und/oder das zweite Filterelement können jeweils eine Induktivität oder einen Ferrit umfassen, welcher ausgebildet ist, für niederfrequente Wechselstromsignale niederohmig zu sein und für hochfrequente Wechselstromsignale hochohmig zu sein. Dadurch kann insbesondere der Vorteil erreicht werden, dass die Filterelemente niederfrequente Signale mit hohen Stromstärken effizient leiten können.

Das Kontaktüberwachungssignal kann vorzugsweise eine Frequenz von 100 kHz bis 100 MHz aufweisen. Die Filterelemente sind für das Kontaktüberwachungssignal in diesem Frequenzbereich hochohmig, sodass das Kontaktüberwachungssignal an den Ausgangsanschlüssen nicht anliegt oder nur mit verringerter Signalamplitude anliegt.

Die Filterelemente erreichen ferner den Vorteil, dass eine niederohmige Überbrückung des elektrischen Kontakts nicht als elektrischen Kontakt in dem ersten Kontaktzustand von der Kontaktüberwachungsvorrichtung fehlinterpretiert werden kann. Insbesondere kann der Realteil eines Impedanzwerts des jeweiligen Filterelements bei einem Kontaktüberwachungssignal mit einer vorbestimmten Frequenz die Größenordnung des Widerstandswerts eines ohmschen Widerstands des Dämpfungselements erreichen. Dadurch kann insbesondere der Vorteil erreich werden, dass mit dem elektrischen Kontakt in dem zweiten Kontaktzustand und einer äußeren niederohmigen Überbrückung des elektrischen Kontakts ein Dämpfungswert entsprechend dem durch das Dämpfungselement vorgesehenen Dämpfungswert erreicht und eine Schwingung des Oszillatorschaltkreises unterbunden werden kann.

In einer Ausführungsform weisen das erste Filterelement und/oder das zweite Filterelement einen ohmschen Impedanzanteil bei der Oszillatorfrequenz auf, welcher ausgebildet ist, ein Erfassen eines externen Kurzschlusses des ersten Ausgangsanschlusses mit dem zweiten Ausgangsanschluss als ein Schließen des elektrischen Kontakts zu unterbinden.

In einer Ausführungsform umfasst das Dämpfungselement eine Kapazität, welche durch einen Leiterplattenkondensator gebildet ist.

In einer Ausführungsform umfasst die Kontaktüberwachungsvorrichtung einen Versorgungsspannungsanschluss, an welchen eine Versorgungsspannung anlegbar ist, wobei mittels des Versorgungsspannungsanschlusses der Oszillatorschaltkreis und/oder der Detektor mit elektrischer Energie versorgbar sind. Ferner kann die Kontaktüberwachungsvorrichtung einen Schaltsteueranschluss aufweisen, welcher mit einem Anschaltsignal beaufschlagbar ist, um den elektrischen Kontakt auszulösen.

In einer Ausführungsform ist der Detektor und/oder der Oszillatorschaltkreis über den Schaltsteueranschluss mit dem Anschaltsignal beaufschlagbar, wobei der Detektor und/oder der Oszillatorschaltkreis ausgebildet sind, mit dem Anschaltsignal mit elektrischer Energie versorgt zu werden. Das Anschaltsignal kann insbesondere ein Gleichspannungssignal sein, welches geeignet ist, den Detektor und/oder den Oszillatorschaltkreis mit elektrischer Energie zu versorgen. In einer Ausführungsform kann mit dem Anschaltsignal ein Pufferkondensator aufgeladen werden, welcher ausgebildet ist, den Detektor und/oder den Oszillatorschaltkreis zumindest für ein vorbestimmtes Zeitintervall mit einer konstanten Spannung und/oder einer konstanten Stromstärke zu versorgen.

In einer Ausführungsform kann zwischen dem Schaltsteueranschluss und dem Pufferkondensator ein Gleichrichter geschaltet sein, welcher ausgebildet ist, ein wechselstromartiges Anschaltsignal in eine Versorgungsspannung für den Detektor und/oder den Oszillatorschaltkreis zu wandeln.

In einer Ausführungsform ist der Pufferkondensator ausgebildet, mit dem Wegfall des Anschaltsignals den Detektor und/oder den Oszillatorschaltkreis für ein vorbestimmtes Zeitintervall weiter mit elektrischer Energie zu versorgen, um ein entsprechend dem Wegfall des Anschaltsignals ein Öffnen des elektrischen Kontakts zu erfassen und ein entsprechendes Ausgabesignal zu erzeugen. Der Detektor kann insbesondere ausgebildet sein, vor einem Abbruch der Energieversorgung des Detektors mit dem Ausgabesignal eine Statusinformation bezüglich eines Kontaktfehlers respektive einem ordnungsgemäßen Schalten des elektrischen Kontakts in Bezug auf das Anschaltsignal auszugeben.

Weitere Ausführungsbeispiele werden Bezug nehmend auf die beiliegenden Figuren erläutert. Es zeigen:

Fig. 1 die Kontaktüberwachungsvorrichtung in einer Ausführungsform;

Fig. 2 die Kontaktüberwachungsvorrichtung in einer Ausführungsform;

Fig. 3 die Impedanz an dem Signaleingang in einer Ausführungsform;

Fig. 4 die Kontaktüberwachungsvorrichtung in einer Ausführungsform;

Fig. 5 die Kontaktüberwachungsvorrichtung in einer Ausführungsform;

Fig. 6 die Kontaktüberwachungsvorrichtung in einer Ausführungsform;

Fig. 7 eine temperaturkompensierte Kontaktüberwachungsvorrichtung in prinzipieller Form;

Fig. 8 ein frequenzbestimmendes Netzwerk der Kontaktüberwachungsvorrichtung in prinzipieller Form;

Fig. 9 zwei Impedanzverläufe des frequenzbestimmenden Netzwerks der Kontaktüberwachungsvorrichtung;

Fig. 10 die temperaturkompensierte Kontaktüberwachungsvorrichtung in einer ersten Ausführungsform;

Fig. 11 die temperaturkompensierte Kontaktüberwachungsvorrichtung in einer zweiten Ausführungsform; und

Fig. 12 die temperaturkompensierte Kontaktüberwachungsvorrichtung in einer dritten Ausführungsform.

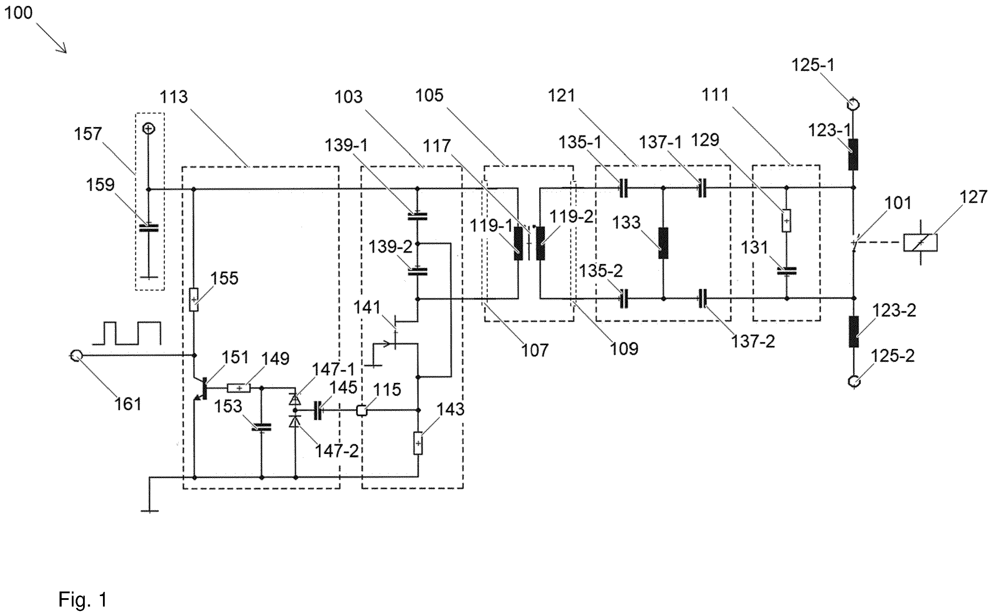

Fig. 1 zeigt eine schematische Darstellung der Kontaktüberwachungsvorrichtung 100 zur Überwachung elektrischen Kontakts 101 mit zumindest zwei Kontaktzuständen gemäß einer Ausführungsform. Die Kontaktüberwachungsvorrichtung 100 weist einen Oszillatorschaltkreis 103 zum Erzeugen eines Anregungssignals und ein Koppelelement 105 mit einem Signaleingang 107 und einem Signalausgang 109 auf.

Der Oszillatorschaltkreis 103 ist dem Signaleingang 107 vorgeschaltet, um das Koppelelement 105 mit dem Anregungssignal zu beaufschlagen, und das Koppelelement 105 ist ausgebildet, das Anregungssignal in ein Kontaktüberwachungssignal zu überführen und das Kontaktüberwachungssignal an dem Signalausgang 109 zum Beaufschlagen des elektrischen Kontakts 101 auszugeben. Ferner umfasst die Kontaktüberwachungsvorrichtung 100 ein Dämpfungselement 111, welches dem Signalausgang 109 nachgeschaltet und dem elektrischen Kontakt 101 vorgeschaltet ist.

Mit dem elektrischen Kontakt 101 in dem ersten Kontaktzustand ist an dem Oszillatorschaltkreis 103 ein erster Impedanzwert eingestellt, und mit dem elektrischen Kontakt 101 in dem zweiten Kontaktzustand ist an dem Oszillatorschaltkreis 103 ein zweiter Impedanzwert eingestellt.

Die Kontaktüberwachungsvorrichtung umfasst ein Dämpfungselement 111, welches dem Signalausgang 109 nachgeschaltet und dem elektrischen Kontakt 101 vorgeschaltet ist, wobei das Dämpfungselement 111 ausgebildet ist, mit dem elektrischen Kontakt 101 in dem zweiten Kontaktzustand eine Impedanz bereitzustellen, um ein Wirken einer Impedanz des elektrischen Kontakts 101 in dem zweiten Kontaktzustand zu unterbinden, wobei mit dem Wirken des Dämpfungselements 111 der Signaleingang 107 des Koppelelements 105 gedämpft ist, der Oszillatorschaltkreis 103 nicht schwingungsfähig ist und eine Ausgabe des Anregungssignals unterbunden ist. Der erste Impedanzwert ist größer, als der zweite Impedanzwert.

Der Oszillatorschaltkreis 103 ist ausgebildet, mit dem elektrischen Kontakt 101 in dem ersten Kontaktzustand und dem ersten Impedanzwert eine Resonanzschwingung zu erzeugen und das Anregungssignal auszugeben, und mit dem elektrischen Kontakt 101 in dem zweiten Kontaktzustand und dem zweiten Impedanzwert eine Ausgabe des Anregungssignals zu unterbinden. Ferner umfasst die Kontaktüberwachungsvorrichtung 100 einen Detektor 113, welcher ausgebildet ist, das Anregungssignals zu erfassen, um einen Kontaktzustandswechsel des elektrischen Kontakts 101 zu überwachen.

Das Dämpfungselement 111 umfasst einen Widerstand 129, welcher ausgebildet ist, einen Impedanzwert an dem Signaleingang 107 derart zu verändern respektive zu belasten, dass ein Schwingkreis, welcher aus dem vorzugsweise induktiven Imaginärteil des Koppelelements 105 und dem vorzugsweise kapazitiven Imaginärteil des Oszillatorschaltkreises 103 gebildet ist, eine hohe Dämpfung erfährt, mit welcher der Oszillatorschaltkreis 103 nicht schwingungsfähig ist und entsprechend das Kontaktüberwachungssignal an dem elektrischen Kontakt 101 nicht anliegt.

Ferner umfasst das Dämpfungselement 111 eine Kapazität 131, welche ausgebildet ist, für ein über die Ausgangsanschlüsse 125-1, 125-2 an dem elektrischen Kontakt 101 anliegendes, insbesondere niederfrequentes Nutzsignal eine hohe erste Impedanz zu erzeugen, um Leckströme durch das Dämpfungselement 111 zu minimieren oder zu unterbinden. Ferner ist die Kapazität 131 ausgebildet, für das Kontaktüberwachungssignal eine niedrige zweite Impedanz zu erzeugen, um eine spektrale Trennung des Kontaktüberwachungssignals und des Nutzsignals zu realisieren.

Die Kapazität 131 weist insbesondere eine hohe Spannungsfestigkeit, beispielsweise größer gleich 30 kV/mm auf, wobei die Kapazität 131 vorzugsweise als Leiterplattenkondensator ausgeführt ist. Dadurch kann insbesondere der Vorteil einer Verringerung einer Anzahl von benötigten diskreten Bauelementen erreicht werden, sodass eine kostengünstigere Herstellung möglich ist. Ferner kann dadurch der Vorteil eines reduzierten Bauraums der Kontaktüberwachungsvorrichtung 100 erreicht werden.

In einer Ausführungsform umfasst die Leiterplattenkapazität 131 Leiterflächen, die auf unterschiedlichen Lagen einer zumindest zweilagigen Leiterplatte angeordnet sind. Dadurch kann beispielsweise der Vorteil erreicht werden, dass mit einem Einsatz der Kontaktüberwachungsvorrichtung 100 in sicherheitsrelevanten Bereichen eine Funktionsstörung der Kontaktüberwachungsvorrichtung 100 auf Basis einer fehlerhaften Kapazität 131 reduziert oder ausgeschlossen sein kann. Insbesondere kann eine Funktionsstörung auf Basis eines Kurzschlusses zwischen verschiedenen Lagen einer Leiterplatte bei einer Fehlerbetrachtung ausgeschlossen sein, sodass ferner der Vorteil erreicht werden kann, dass die Kontaktüberwachungsvorrichtung 100 mit reduzierten Herstellungskosten herstellbar ist.

Mit einem Schließen des elektrischen Kontakts 101, d.h. einem Wechsel des elektrischen Kontakts 101 von dem zweiten Kontaktzustand in den ersten Kontaktzustand, wird das Dämpfungselement 111 aufgrund der Parallelschaltung des Dämpfungselements 111 und des elektrischen Kontakts 101 niederohmig überbrückt und wirkt entsprechend weder für ein an dem elektrischen Kontakt 101 anliegendes Nutzsignal, noch für das Kontaktüberwachungssignal. Mit der Überbrückung des Dämpfungselements 111 ist eine mittels des Widerstands 129 des Dämpfungselements 111 erzeugbare transformierte Dämpfung an dem Signaleingang 107 reduziert, sodass der Schwingkreis nur geringe ohmsche Verluste aufweist. Ferner ist der Schwingkreis ausgebildet, mit der reduzierten Dämpfung eine Resonanzschwingung zu erzeugen.

Der Oszillatorschaltkreis 103 kann als ein Colpitts-Oszillator aufgebaut sein, welcher die Kapazitäten 139-1, 139-2 und einen Transistor 141 umfasst. Der Transistor 141 ist ausgebildet, das Anregungssignal zu verstärken. Ferner umfasst der Oszillatorschaltkreis 103 einen Widerstand 143, über welchen das Anregungssignal an den Detektor 113 geleitet werden kann. Die Induktivität 119-1, welche als eine Spule ausgebildet sein kann, kann ein Element des Oszillatorschaltkreises 103 bilden.

Der Detektor 113 kann einen Kondensator 145 umfassen, welcher ausgebildet ist, einen Gleichanteil des Anregungssignals abzutrennen. Ferner umfasst der Detektor 113 zumindest zwei Dioden 147-1, 147-2 und einen weiteren Kondensator 153, wobei die Dioden 147-1, 147-2 und der Kondensator 145 ausgebildet sind, das Anregungssignal in ein gleichgerichtetes Ausgabesignal zu überführen. Weiterhin weist der Detektor 113 einen Widerstand 149 und einen Transistor 151 auf, wobei über den Widerstand 149 der Transistor 151 durchgeschaltet wird, wenn an dem Detektorausgang 115 eine von dem Oszillatorschaltkreis 103 erzeugte Schwingung als Anregungssignal anliegt. Weiterhin umfasst der Detektor 113 einen Pull-Up-Widerstand 155, wobei der Detektor 113 ausgebildet ist, über den Pull-Up-Widerstand 155 das Ausgabesignal bereitzustellen, wobei das Ausgabesignal insbesondere ein invertiertes Signal ist, welches eine logische 0 ausgibt, wenn der elektrische Kontakt 101 geschlossen, respektive in dem ersten Kontaktzustand ist, und eine logische 1 ausgibt, wenn der elektrische Kontakt 101 geöffnet, respektive in dem zweiten Kontaktzustand ist.

In einer Ausführungsform umfasst der Detektor 113 einen Ausgabesignalanschluss 161 und ist ausgebildet, das Ausgabesignal zu invertieren, um mit dem elektrischen Kontakt 101 in dem ersten Kontaktzustand eine logische 1 an dem Ausgabesignalanschluss 161 auszugeben und mit dem elektrischen Kontakt 101 in dem zweiten Kontaktzustand eine logische 0 an dem Ausgabesignalanschluss 161 auszugeben.

Ferner umfasst die Kontaktüberwachungsvorrichtung 100 einen Versorgungsspannungsanschluss 157, an welchen eine Versorgungsspannung anlegbar ist, wobei mittels des Versorgungsspannungsanschlusses 157 der Oszillatorschaltkreis 103 und/oder der Detektor 113 mit elektrischer Energie versorgbar sind. Der Versorgungsspannungsanschluss 157 kann einen Glättungskondensator 159 umfassen, welcher ausgebildet ist, eine Versorgungsspannung zu glätten. Ferner kann der Glättungskondensator 159 als ein Pufferkondensator ausgebildet sein, welcher ausgebildet ist, für ein vorbestimmtes Zeitintervall dem Oszillatorschaltkreis 103 und/oder dem Detektor 113 elektrische Energie bereitzustellen, insbesondere auch dann, wenn eine externe Energieversorgung über den Versorgungsspannungsanschluss 157 abbricht.

Das Koppelement 105 umfasst einen Transformator 117, welcher ausgebildet ist, den Oszillatorschaltkreis 103 induktiv an die Impedanzschaltung 121 und das Dämpfungselement 111 zu koppeln.

Die Impedanzschaltung 121 umfasst die Kapazitäten 135-1, 135-2, welche ausgebildet sind, eine Streuinduktivität, insbesondere eine Streuinduktivität des Transformators 117 bei einer vorbestimmten Frequenz des von dem Oszillatorschaltkreis 103 generierten Anregungssignals zu kompensieren. Die Kapazitäten 135-1, 135-2 erreichen insbesondere den Vorteil einer Minimierung einer Gesamtkapazität der galvanischen Trennung mittels des Koppelelements 105 und/oder den Vorteil eines symmetrischen Aufbaus. Die Kapazitäten 135-1, 135-2 können insbesondere durch Kondensatoren gebildet sein, welche gleiche Kapazitätswerte aufweisen.

Ferner umfasst die Impedanzschaltung 121 die Kapazitäten 137-1, 137-2 und die Induktivität 133. In einer Ausführungsform kann nur eine der Kapazitäten 137-1, 137-2 und/oder nur eine der Kapazitäten 135-1, 135-2 vorgesehen sein.

Die Induktivität 133 bildet mit den Kapazitäten 137-1, 137-2 ein LC-Glied, welches ausgebildet ist, auf elektrische Signale entsprechend einer elektrischen Leitung mit invertierbarer Impedanz zu reagieren. Ein Induktivitätswert der Induktivität 133 und ein Kapazitätswert der Kapazitäten 137-1, 137-2 kann derart gewählt werden, dass mit dem elektrischen Kontakt 101 in dem ersten Kontaktzustand das LC-Glied einen hohen Impedanzwert aufweist, um den Signalausgang 109 des Koppelelements 105 hochohmig und entsprechend unbelastet zu schalten. Dadurch kann ein Impedanzwert an dem Signaleingang 107 einen hohen Realanteil aufweisen, mit welchem ein Erzeugen des Anregungssignals durch den Oszillatorschaltkreis 103 unterbunden sein kann.

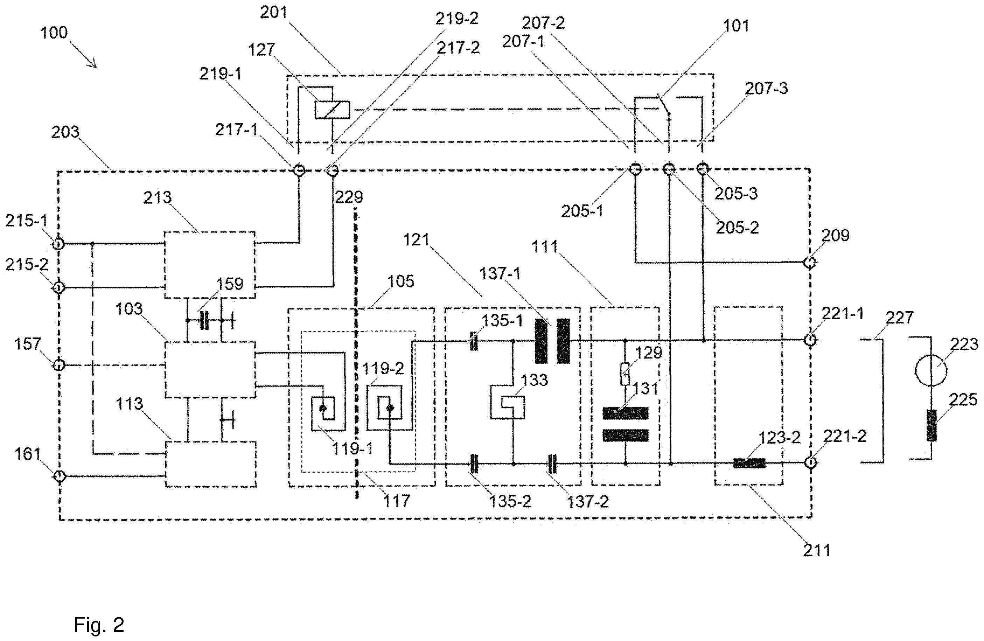

Fig. 2 zeigt eine schematische Darstellung der Kontaktüberwachungsvorrichtung 100 zur Überwachung eines elektrischen Kontakts 101 mit zumindest zwei Kontaktzuständen gemäß einer Ausführungsform. Die Kontaktüberwachungsvorrichtung 100 ist in einen Modulsockel 203 integriert, wobei der elektrische Kontakt 101 Teil eines Schaltmoduls 201 ist. Der Modulsockel 203 umfasst drei Schaltkontaktanschlüsse 205-1, 205-2, 205-3, welche insbesondere als Buchsenstecker ausgeführt sind. Ferner umfasst das Schaltmodul 201 entsprechende Steckkontakte 207-1, 207-2, 207-3, welche in die Schaltkontaktanschlüsse 205-1, 205-2, 205-3 einführbar und mit diesen elektrisch verbindbar sind, um den elektrischen Kontakt 101 mit dem Dämpfungselement 111 zu verbinden, insbesondere mit dem Dämpfungselement 111 elektrisch parallel zu schalten.

Der elektrische Kontakt 101 kann insbesondere ein dreipoliger Schalter sein, welcher ausgebildet ist, in einem ersten Kontaktzustand die Steckkontakte 207-3 und 207-2 elektrisch leitend zu verbinden und in einem zweiten Kontaktzustand die Steckkontakte 207-1 und 207-2 elektrisch leitend zu verbinden. Die Kontaktüberwachungsvorrichtung 100 ist ausgebildet, ein Öffnen und ein Schließen der elektrischen Verbindung zwischen dem Steckkontakt 207-3 und dem Steckkontakt 207-2 zu erfassen. Der Steckkontakt 207-1 kann über einen über einen Durchgangsanschluss 209 an eine weitere Kontaktüberwachungsvorrichtung 100 weitergeleitet werden, um auch die elektrische Verbindung zwischen den Steckkontakten 207-1 und 207-2 zu überwachen. Ferner kann die Kontaktüberwachungsvorrichtung 100 ausgebildet sein, die Steckkontakte 207-1 und 207-2 über die Steckbuchsen 205-1 und 205-2 mit einem weiteren Kontaktüberwachungssignal zu beaufschlagen, um die die elektrische Verbindung zwischen den Steckkontakten 207-1 und 207-2 zu überwachen.

Die Kontaktüberwachungsvorrichtung 100 weist ein Filtermodul 211 auf, welches das Filterelement 123-2 umfasst. Das Filterelement 123-2 kann durch eine einzelne Induktivität gebildet sein, welche insbesondere als ein HF-Ferrit ausgebildet ist. Mit einem Verzicht auf ein weiteres Filterelement kann der Vorteil reduzierter Herstellungskosten mit einem zuverlässigen Betrieb der Kontaktüberwachungsvorrichtung 100 erreicht werden.

Die Kapazität 131 des Dämpfungselements 111 kann als Leiterplattenkondensator gebildet sein, um eine erhöhte Spannungsfestigkeit aufzuweisen. Ferner ist zumindest eine der Kapazitäten 137-1, 137-2, beispielsweise die Kapazität 137-1 als ein hochspannungsfester Leiterplattenkondensator gebildet. Die Kapazitäten 137-1, 131 können bevorzugterweise jeweils einen Kapazitätswert im pF-Bereich aufweisen. Weiter bevorzugt weisen die Kapazitäten 137-1, 137-2 jeweils einen Kapazitätswert kleiner als 100 pF auf. Ferner können auch die weiteren Kapazitäten 135-1, 135-2 einen Kapazitätswert in pF-Bereich oder jeweils einen Kapazitätswert kleiner als 100 pF aufweisen. Mit geringen Kapazitätswerten kann insbesondere der Vorteil erreicht werden, dass beispielsweise bei Wechselstromanwendungen über die Impedanzschaltung 121 und/oder das Dämpfungselement 111 geringe, insbesondere vernachlässigbarer Leckströme fließen.

Die Induktivität 133 kann als eine Planarspule in Form einer spiralförmigen Leiterbahn ausgebildet sein.

In einer Ausführungsform kann der Detektor 113 ausgebildet sein, an dem Ausgabesignalanschluss 161 nur dann ein Ausgabesignal bereitzustellen, wenn ein Schaltfehler des elektrischen Kontakts 101 vorliegt. Der Detektor 113 kann ausgebildet sein, einen Schaltfehler des elektrischen Kontakts 101 anhand einer logischen Abweichung zwischen dem Anregungssignal und dem Anschaltsignal, welches zum Auslösen des elektrischen Kontakts 101 dient, zu erfassen.

Der Schaltmodulsockel 203 kann ferner einen ersten Schaltsteueranschluss 215-1 und/oder einen zweiten Schaltsteueranschluss 215-2 aufweisen, wobei an die Schaltsteueranschlüsse 215-1, 215-2 das Anschaltsignal anlegbar ist, um den elektrischen Kontakt 101 in dem Schaltmodul 201 auszulösen. Der Gleichrichter 213 ist den ersten Schaltsteueranschluss 215-1 und/oder dem zweiten Schaltsteueranschluss 215-2 vorgeschaltet und ausgebildet, das Anschaltsignal in ein gleichgerichtetes Anschaltsignal zu wandeln. Ferner umfasst der Schaltmodulsockel 203 einen ersten Schaltsignalausgang 217-1 und/oder einen zweiten Schaltsignalausgang 217-2, wobei der Gleichrichter 213 ausgebildet ist das gleichgerichtete Anschaltsignal an dem ersten Schaltsignalausgang 217-1 und/oder einen zweiten Schaltsignalausgang 217-2 bereitzustellen.

Das Schaltmodul 201 umfasst einen ersten Schaltanschlussstecker 219-1 und/oder einen zweiten Schaltanschlussstecker 219-2. Der erste Schaltanschlussstecker 219-1 ist bei einem Einstecken des Schaltmoduls 201 in den Schaltmodulsockel 203 mit dem ersten Schaltsignalausgang 217-1 elektrisch verbindbar und/oder der zweite Schaltanschlussstecker 219-2 ist bei einem Einstecken des Schaltmoduls 201 in den Schaltmodulsockel 203 mit dem zweiten Schaltsignalausgang 217-2 elektrisch verbindbar, um das Schaltelement mit dem Anschaltsignal zu beaufschlagen.

In einer Ausführungsform kann das Anschaltsignal dem Detektor 113 zugeführt sein, wobei der Detektor 113 ausgebildet ist, das Anschaltsignal in Bezug auf das Anregungssignal auszuwerten, um ein Schalten und/oder einen Kontaktzustand des elektrischen Kontakts 101 in Abhängigkeit des Anschaltsignals zu erfassen und ein entsprechendes Ausgangssignal an dem Ausgabesignalanschluss 161 bereitzustellen.

Die Kapazitäten 135-1, 135-2, 137-1, 137-2, 131, 139-1, 139-2, insbesondere die Koppelkondensatoren, können jeweils oder als Teilmenge durch Leiterflächen gebildet sein, die auf verschiedenen Lagen einer zumindest zweilagigen Leiterplatte angeordnet sind. Zwischen den metallischen Leiterflächen kann ein Kunststoffmaterial der Leiterplatte angeordnet sein, sodass eine Kapazität als Leiterplattenkondensator gebildet ist.

Ferner umfasst die Kontaktüberwachungsvorrichtung 100 einen Versorgungsspannungsanschluss 157, an welchen eine Versorgungsspannung anlegbar ist, wobei mittels des Versorgungsspannungsanschlusses 157 der Oszillatorschaltkreis 103 und/oder der Detektor 113 mit elektrischer Energie versorgbar sind. Der Versorgungsspannungsanschluss 157 kann insbesondere durch eine Versorgungsklemme gebildet sein.

Die Kontaktüberwachungsvorrichtung 100 umfasst ferner einen ersten Lastanschluss 221-1 und einen zweiten Lastanschluss 221-2, welche jeweils dem Filtermodul 211 nachgeschaltet sind. Der erste Lastanschluss 221-1 ist mit dem dritten Schaltkontaktanschluss 205-3 elektrisch verbunden und der zweite Lastanschluss 221-2 ist mit dem zweiten Schaltkontaktanschluss 205-2 elektrisch verbunden. Insbesondere ist der erste Lastanschluss 221-1 mit einer Lastspannungsversorgung 223 verbindbar und ausgebildet, ein Lastspannungssignal über den dritten Schaltkontaktanschluss 205-3 und den dritten Steckkontakt 207-3 an den elektrischen Kontakt 101 anzulegen.

Der zweite Lastanschluss 221-2 ist mit einer elektrischen Last 225 elektrisch verbindbar, wobei mit dem elektrischen Kontakt 101 in dem ersten Kontaktzustand das Lastspannungssignal an der elektrischen Last 225 anliegt. Ferner können die Lastanschlüsse 221-1, 221-2 mit einer Leitungsbrücke 227 kurzgeschlossen werden. Dadurch kann beispielsweise ein Testfall für die Kontaktüberwachungsvorrichtung 100 generiert werden, um ein zuverlässiges Erkennen des Kontaktzustandes des elektrischen Kontakts 101 auch bei einer niederohmigen Überbrückung des elektrischen Kontakts 101, insbesondere bei einem externen Kurzschluss zu überprüfen.

Das Koppelement 105 umfasst einen Transformator 117, welcher ausgebildet ist, den Oszillatorschaltkreis 103 induktiv an die Impedanzschaltung 121 und das Dämpfungselement 111 zu koppeln. Der Transformator 117 weist eine erste Induktivität 119-1, insbesondere eine erste Planarspule, und eine zweite Induktivität 119-2, insbesondere eine zweite Planarspule, auf, wobei die erste Induktivität 119-1 mit der zweiten Induktivität 119-2 induktiv gekoppelt ist, um das Anregungssignal in das Kontaktüberwachungssignal zu überführen. Der Transformator 117 ist ausgebildet, den Oszillatorschaltkreis 103 von der Impedanzschaltung 121, dem Dämpfungselement 111 und/oder dem elektrischen Kontakt 101 galvanisch zu trennen. Die galvanische Trennung ist durch die Trennlinie 229 angezeigt.

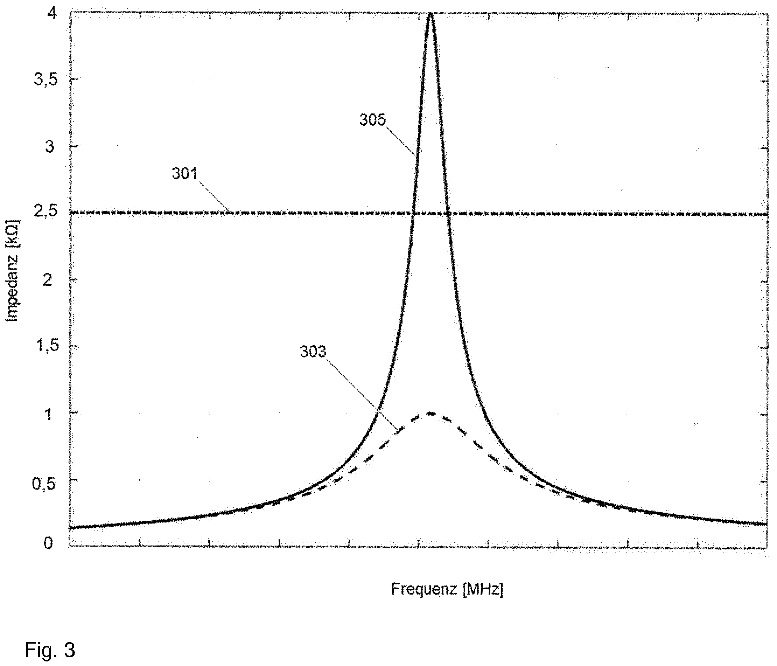

Fig. 3 zeigt die frequenzabhängige Impedanz an dem Signaleingang in einer Ausführungsform. An dem Signaleingang wirkt eine Induktivität, welche insbesondere durch die Hauptinduktivität des Transformators des Koppelelements gebildet ist. Die Induktivität kann beispielsweise einen Induktivitätswert von 200 nH aufweisen. An dem Signaleingang wirkt ferner eine Kapazität, welche insbesondere durch die Kapazitäten des Oszillatorschaltkreises gebildet sind. Die Kapazität kann beispielsweise einen Kapazitätswert von 50 pF aufweisen. Weiterhin wirkt an dem Signaleingang ein ohmscher Widerstand, welcher insbesondere durch eine mittels des Transformattors transformierte signalausgangsseitige Impedanz gebildet ist. Mit dem elektrischen Kontakt in dem ersten Kontaktzustand, d.h. mit einem geschlossenen, elektrisch leitfähigen elektrischen Kontakt, kann an dem Signaleingang ein erster Widerstand mit einem Widerstandswert von beispielsweise 4 kΩ wirken. Mit dem elektrischen Kontakt in dem zweiten Kontaktzustand, d.h. mit einem geöffneten, elektrisch isolierenden elektrischen Kontakt, kann an dem Signaleingang ein zweiter Widerstand mit einem Widerstandswert von beispielsweise 1 kΩ wirken.

Der an dem Signaleingang wirkende Widerstand kann entsprechend dem Kontaktzustand derart variieren, dass mit einem ersten Widerstand der Oszillatorschaltkreis schwingungsfähig ist und das Anregungssignal mit einer Resonanzsignalamplitude erzeugen kann und mit dem zweiten Widerstand der Oszillatorschaltkreis nicht schwingungsfähig ist und das Anregungssignal nicht erzeugen kann.

Der Oszillatorschaltkreis kann ausgebildet sein, mit einem Widerstandsgrenzwert 301 größer 2,5 kΩ von einem nichtschwingungsfähigen Zustand in einen schwingungsfähigen Zustand überzugehen. Die Kontaktüberwachungsvorrichtung 111 ist durch eine entsprechende Dimensionierung der elektrischen Komponenten ausgebildet, eine erste Impedanzkurve 303 und eine zweite Impedanzkurve 305, durch eine möglichst große Amplitudendifferenz zu trennen. Die Amplitudendifferenz kann dabei mit einer Impedanzdifferenz an dem Signaleingang basierend auf dem ersten Kontaktzustand und dem zweiten Kontaktzustand skalieren. Mit der ersten Impedanzkurve 303 ist der Oszillatorschaltkreis in einem nichtschwingungsfähigen Zustand und das Anregungssignal kann nicht erzeugt werden. Mit der zweiten Impedanzkurve 305 ist der Oszillatorschaltkreis in einem schwingungsfähigen Zustand und das Anregungssignal kann erzeugt werden.

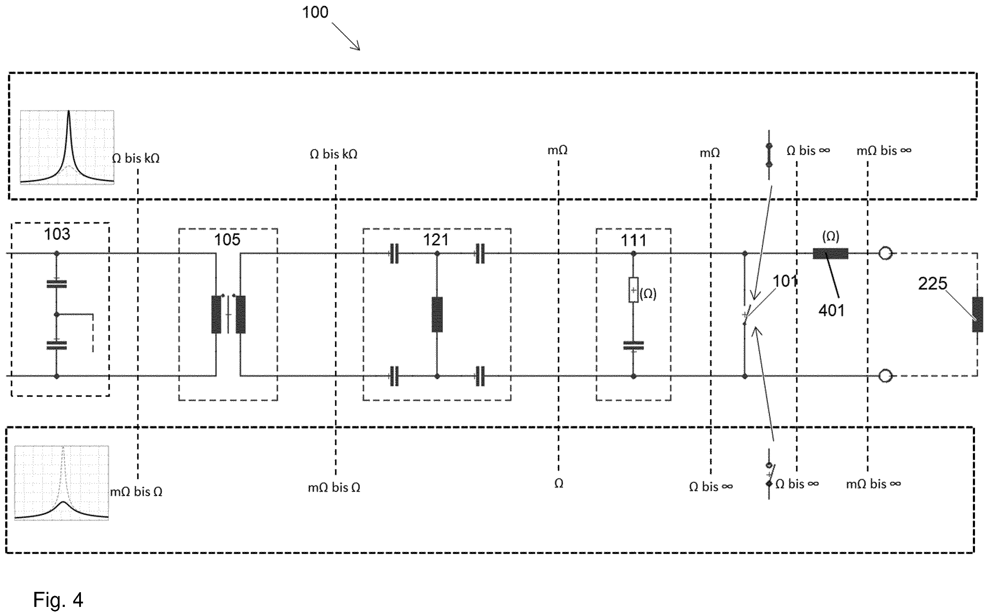

Fig. 4 zeigt eine schematische Darstellung der Kontaktüberwachungsvorrichtung 100 in einer Ausführungsform. Zwischen den jeweiligen Elementen ist die jeweils zu erwartende Impedanz in Ohm für die zu erwartende Oszillatorfrequenz angegeben. Oberhalb der schematischen Darstellung der Kontaktüberwachungsvorrichtung 100 ist die Impedanz für den elektrischen Kontakt 101 in dem ersten Kontaktzustand, respektive für den geschlossenen elektrischen Kontakt 101 angegeben.

Ferner ist unterhalb der schematischen Darstellung der Kontaktüberwachungsvorrichtung 100 die Impedanz für den elektrischen Kontakt 101 in dem zweiten Kontaktzustand, respektive für den geöffneten elektrischen Kontakt 101 angegeben. Die Last 225 kann typischerweise eine Impedanz in dem Bereich von $m\Omega$ bis $\infty\Omega$ aufweisen.

Dem Kontakt 101 ist ein Ferrit mit einem ohmschen Impedanzanteil im $\Omega$-Bereich nachgeschaltet.

Das Dämpfungselement 111 und/oder das Filterelement sind ausgebildet, bereits zwischen dem Dämpfungselement 111 und der Impedanzschaltung 121 eine Impedanz unabhängig von einer äußeren Beschaltung der Kontaktüberwachungsvorrichtung 100, insbesondere unabhängig von einer externen Last 225, definiert bereitzustellen. Dadurch kann der Vorteil erreicht werden, dass bei einem geöffneten elektrischen Kontakt an dieser Stelle der Impedanzwert oder ein Impedanzbereich vorbestimmt ist.

Insbesondere kann unterbunden werden, dass ein äußerer, respektive lastseitiger Kurzschluss auch bei geöffnetem elektrischen Kontakt 101 zu einer Impedanz an dem Oszillatorschaltkreis 103 führt, welche ein Erzeugen einer Schwingung und dementsprechend ein Erzeugen des Anregungssignals zulässt. Dementsprechend kann unterbunden werden, dass ein äußerer Kurzschluss als ein geschlossener elektrischen Kontakt 101 fehlinterpretiert wird.

Die Impedanzschaltung 121 kann ausgebildet sein, mit dem geschlossenen elektrischen Kontakt eine schaltkontaktseitige kleine Impedanz auf eine koppelelementseitige große Impedanz zu transformieren. Ferner kann die Impedanzschaltung 121 ausgebildet sein, mit dem geöffneten elektrischen Kontakt eine schaltkontaktseitige große Impedanz auf eine koppelelementseitige kleine Impedanz zu transformieren. Die angegebenen Impedanzbereiche entsprechen dem Betrag der Impedanz an der jeweiligen Stelle in der Schaltung bezogen auf einen Hochfrequenzbereich.

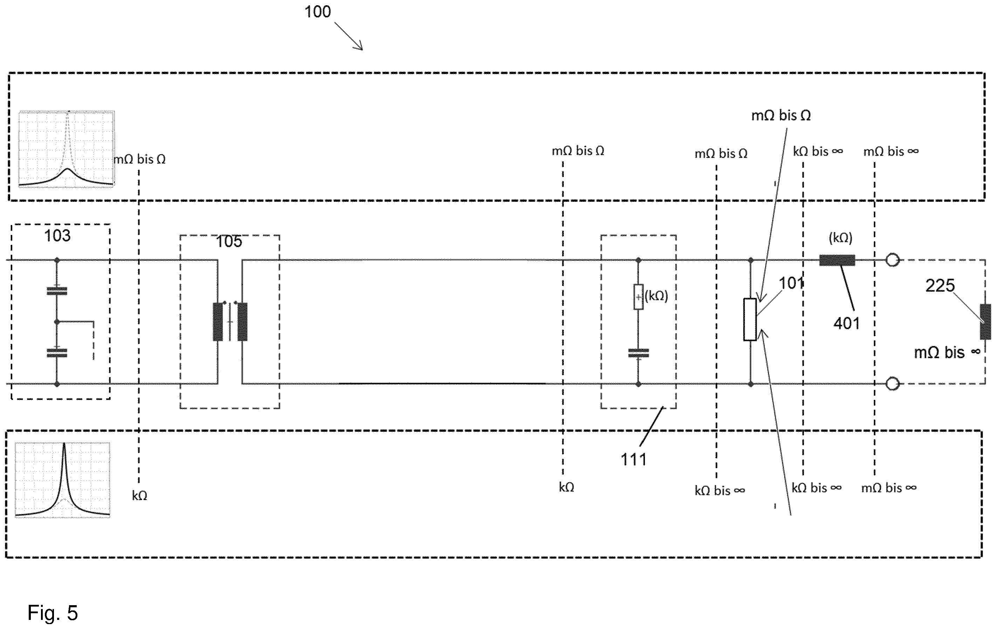

Fig. 5 zeigt eine schematische Darstellung der Kontaktüberwachungsvorrichtung 100 in einer Ausführungsform. Der elektrische Kontakt 101 ist eine Überstrom- und/oder Überspannungssicherung, insbesondere eine Schmelzsicherung. Zwischen den jeweiligen Elementen ist die jeweils zu erwartende Impedanz in Ohm angegeben. Oberhalb der schematischen Darstellung der Kontaktüberwachungsvorrichtung 100 ist die Impedanz für den elektrischen Kontakt 101 in dem ersten Kontaktzustand, respektive für die nicht ausgelöste Sicherung angegeben.

Ferner ist unterhalb der schematischen Darstellung der Kontaktüberwachungsvorrichtung 100 die Impedanz für den elektrischen Kontakt 101 in dem zweiten Kontaktzustand, respektive für eine ausgelöste Sicherung angegeben. Die Last 225 kann eine Impedanz in dem Bereich von $m\Omega$ bis $\infty\Omega$ aufweisen.

Ist der elektrische Kontakt 101 geschlossen, respektive leitfähig, ist der Oszillatorschaltkreis 103 nicht schwingfähig. Ist der elektrische Kontakt 101 geöffnet, respektive die Sicherung hat ausgelöst, ist der Oszillatorschaltkreis schwingfähig. Dadurch kann insbesondere der Zustand einer (Schmelz)-Sicherung überwacht werden. Das Filterelement kann beispielsweise einen ohmschen Widerstand im kOhm-Bereich aufweisen.

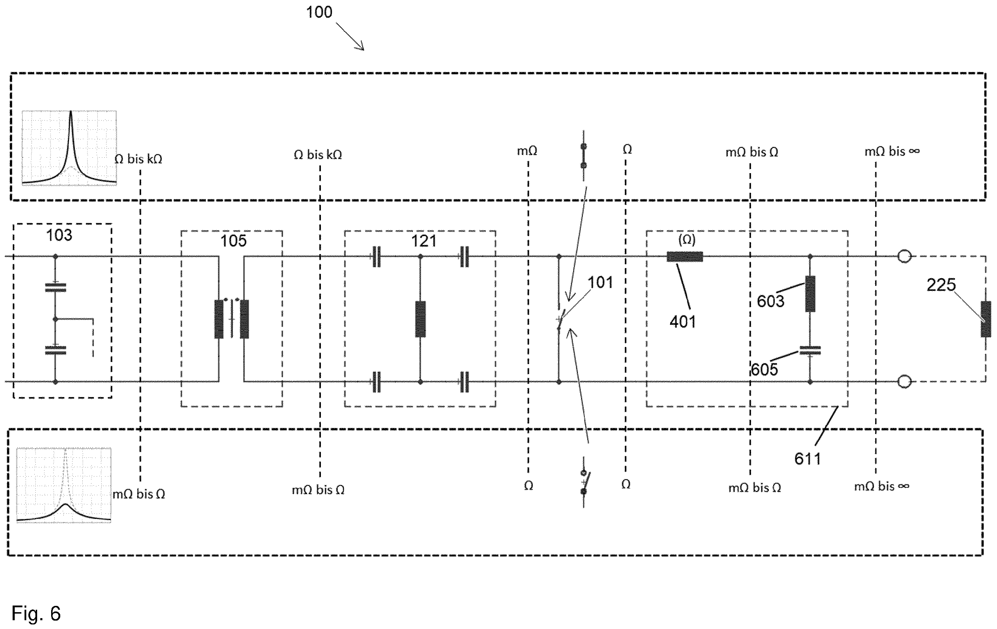

Fig. 6 zeigt eine schematische Darstellung der Kontaktüberwachungsvorrichtung 100 in einer Ausführungsform. Im Unterschied zu der beispielsweise in Fig. 5 dargestellten Ausführungsform ist ein Dämpfungselement 611 vorgesehen, welches dem Kontakt 101, welcher als Schalter ausgebildet sein kann, nachgeschaltet ist.

Das Dämpfungselement 611 umfasst eine Schaltung mit dem Ferrit 401, welcher eine Signaldämpfung hervorruft.

Dem Ferrit 401 ist ein LC-Reihenschwingkreis mit einer Induktivität 603 und einer Kapazität 605 nachgeschaltet. Der LC-Reihenschwingkreis ist vorgesehen, eine geringe Impedanz bei der Schwingfrequenz auszubilden, wodurch das Kontaktüberwachungssignal an den Klemmen minimiert bzw. reduziert werden kann.

In einer Ausführungsform kann die Induktivität 603 auch wegfallen.

In einer Ausführungsform kann das Dämpfungselement 611 in dem Filtermodul 211 integriert sein.

Das Dämpfungselement 611 entspricht in der Funktion dem Dämpfungselement 111. Darüber hinaus kann das Dämpfungselement 611 aufgrund des LC-Schwingkreises eine Filtercharakteristik und bildet daher in einer Ausführungsform ein Filter.

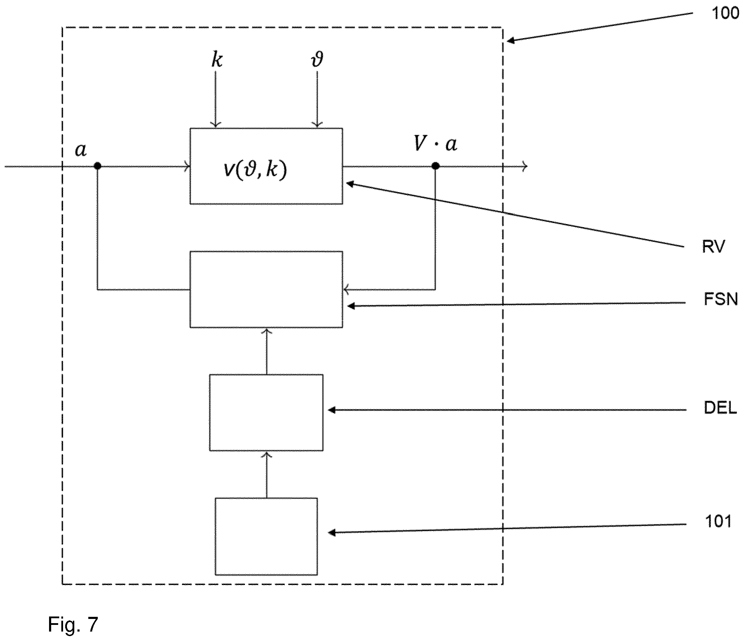

Im Folgenden werden Ausführungsbeispiele erläutert für eine temperaturkompensierte Kontaktüberwachungsvorrichtung. In Fig. 7 ist ein prinzipielles Blockdiagramm der erfindungsgemäßen Kontaktüberwachungsvorrichtung 100 mit Temperaturkompensation dargestellt. Die Kontaktüberwachungsvorrichtung 100 beinhaltet eine Oszillatorschaltung, die aus einem Verstärker RV und einem frequenzselektiven Netzwerk FSN besteht. Auf das frequenzselektive Netzwerk FSN wirkt ein Dämpfungselement DEL. Die wirkende Dämpfung wird von dem Zustand eines zu überwachenden Kontakts 101 bestimmt. Der Verstärker RV kann eine von der Temperatur $\vartheta$ und dem Arbeitspunkt k des Verstärkers abhängige Verstärkung aufweisen. Typischerweise ist der Temperatureinfluss so, dass sich durch eine Temperaturänderung die Transistorströme verändern und sich dadurch eine veränderte Verstärkung ergibt. Dies stellt ein Problem dar, wie nachfolgend noch genauer erläutert wird.

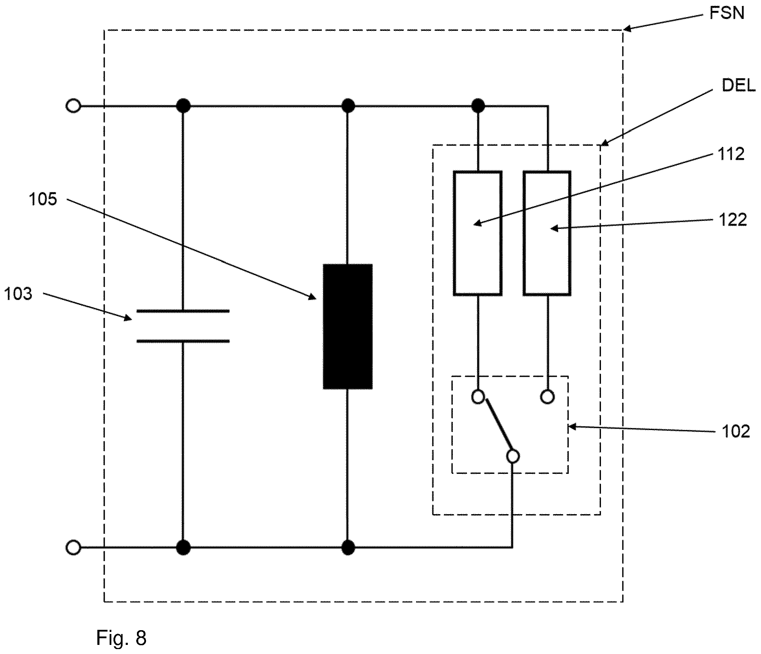

Zunächst wird die Funktion der Kontaktüberwachungsvorrichtung 100 vom Prinzip her nochmals erläutert, s. Fig. 8. In Fig. 8 ist eine Schaltungsdarstellung des frequenzselektiven Netzwerks FSN aus Fig. 7 dargestellt. Ein Zustand (z.B. Kontaktschluss ja/nein) bei dem zu überwachenden Kontakt 101 kann die Dämpfung des Dämpfungselementes DEL des frequenzselektiven Netzwerks FSN beeinflussen. Die Dämpfung des frequenzselektiven Netzwerks FSN wird durch die Dämpfungselemente bzw. wirksamen Widerstände 112 und 122 repräsentiert, die jeweils einen unterschiedlichen Widerstandswert aufweisen. Der Zustand des zu überwachenden Kontakts 101 beeinflusst die Stellung des dargestellten Schalters 102, der, je nach Schalterstellung, einen der beiden Dämpfungswiderstände 112 und 122 mit dem Rest des frequenzselektiven Netzwerks FSN verbindet. Das frequenzselektive Netzwerk FSN wird zusätzlich durch eine Parallelschaltung einer Induktivität 105 und einer Kapazität 103 gebildet. Die Oszillatorschaltung kann für einen Arbeitspunkt k so ausgelegt werden, dass die Verstärkung V des Verstärkers RV für einen ersten Zustand eine kleine Dämpfung 112 kompensiert und am Eingang 114 ein oszillierendes Eingangssignal a oder am Ausgang 115 ein oszillierendes Ausgangssignal V*a beobachtet werden kann. Gleichzeitig kann die Oszillatorschaltung so ausgelegt werden, dass eine größere Dämpfung 122 wirkt, wenn der Schaltkontakt 102 einen zweiten Zustand einnimmt. Dies wirkt sich dann so aus, dass am Eingang 114 wie auch am Ausgang 115 kein oszillierendes Ausgangssignal V*a ansteht.

Bekanntlich muss ein Schwingkreis die Schwingbedingung erfüllen, damit es zu einer stabilen Schwingung kommt. Sie lautet anschaulich:

- Die Schleifenverstärkung muss für eine stabile Oszillation größer oder gleich 1 sein.
- Die Phasenverschiebung der Rückkopplungsschleife muss bei dieser Frequenz ein ganzzahliges Vielfaches von 360° betragen.

Genau dies wird bei der Kontaktüberwachungsvorrichtung ausgenutzt. In dem einen Schaltzustand des Schaltkontaktes wird die Schwingbedingung erfüllt und in dem anderen Schaltzustand des Schaltkontakts wird der Schwingkreis so bedämpft, dass es nicht zu einer stabilen Schwingung kommt (Die Verstärkung des Oszillators ist nicht groß genug, um die Verluste durch die Dämpfung zu kompensieren).

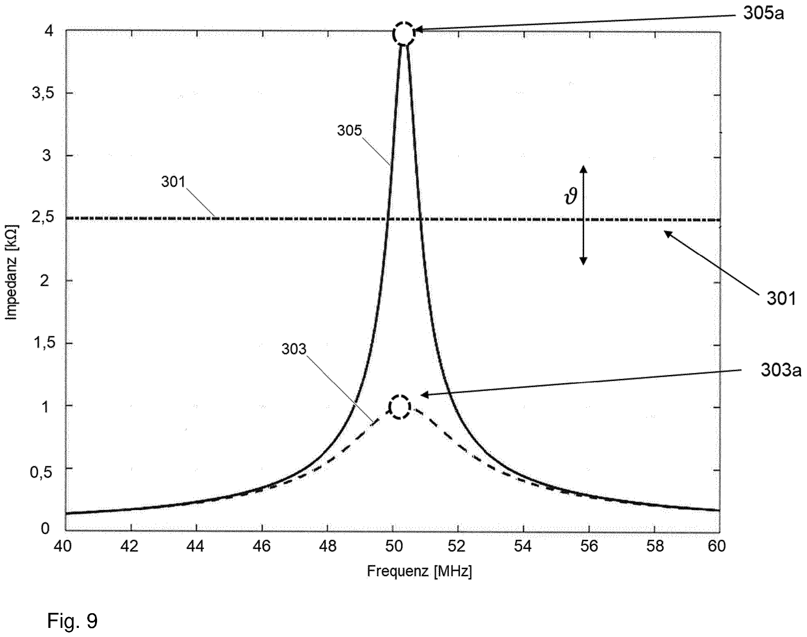

Diese Problematik wird jetzt im Zusammenhang mit der Fig. 9 verdeutlicht. In Fig. 9 ist die Impedanzkurve (Frequenzgang) eines Parallelschwingkreises dargestellt. Wenn der zu überwachende Schaltkontakt nun in den Zustand mit geringer Dämpfung geschaltet ist, schwingt der Oszillator der Kontaktüberwachungsvorrichtung mit der Resonanzfrequenz bei ca. 50,2 MHz mit dem Impedanzverlauf wie bei dem Impedanzfrequenzgang 305 angegeben, s. Punkt 305a. Ist der Schaltkontakt hingegen in den Zustand hoher Dämpfung geschaltet, folgt der Oszillator der Kontaktüberwachungsvorrichtung dem Impedanzverlauf wie bei dem Impedanzfrequenzgang 303 angegeben, s. Punkt 303a. In diesem Zustand mit starker Dämpfung 303 kommt es nicht zu einer stabilen Schwingung. Die Schwinggrenze 301 ist abhängig von der konkreten Schaltung sowie dem Verstärkerelement und sollte möglichst in der Mitte der beiden Kurven liegen, damit je nach Kontaktzustand der Oszillator sicher schwingt oder sicher nicht schwingt.

Dieses gewünschte Verhalten der Oszillatorschaltung kann durch eine Temperaturänderung gestört werden. Besonders der Verstärker RV zeigt ein temperaturabhängiges Verhalten.

Das liegt daran, dass der Verstärkungsfaktor des Verstärkers RV temperaturabhängig ist. Dies gilt insbesondere auch für Transistorverstärker, denn bei Halbleitermaterialien ändert sich mit der Temperatur die Eigenleitung und somit die Transistorströme. Dies kann das erwünschte Verhalten der Oszillatorschaltung stören bis hin zu Fehlfunktionen, wo in einem Temperaturbereich es bei beiden wirksamen Dämpfungen 112 und 122 zu oszillierenden Signalen am Ausgang 115 kommt und/oder in einem anderen Temperaturbereich für beide wirksame Dämpfungen 112 und 122 es nicht zu oszillierenden Signalen am Ausgang 115 kommt, sodass eine sichere Unterscheidung der Zustände durch die Kontaktüberwachungsvorrichtung nicht mehr möglich ist.

In einer Weiterbildung der Erfindung wird die Temperaturabhängigkeit der Oszillatorschaltung kompensiert, indem der Arbeitspunkt des Verstärkers RV in Abhängigkeit der Temperatur verschoben wird, also k -> k($\vartheta$), sodass die Verstärkung des Verstärkers RV eine zu vernachlässigende oder gar keine Temperaturabhängigkeit aufweist.

In Fig. 9 ist der Impedanzfrequenzgang des frequenzselektiven Netzwerks FSN aus Fig. 8 dargestellt. Je nachdem, ob der Dämpfungswiderstand 112 oder 122 wirkt, ergeben sich unterschiedliche Impedanzverläufe 303 bzw. 305. Die Beschreibung der Impedanzverläufe wurde schon im Zusammenhang mit der Beschreibung der Fig. 3 erläutert. Bei der Resonanzfrequenz im Punkt 305a kommt es im Fall des Impedanzverlaufs 305 zu einer Resonanzschwingung und am Eingang 114 und am Ausgang 115 tritt das oszillierende Signal auf. Bei der Resonanzfrequenz im Punkt 303a kommt es im Fall des Impedanzverlaufs 303 nicht zu einer Resonanzschwingung und am Eingang 114 und am Ausgang 115 tritt kein oszillierendes Signal auf.

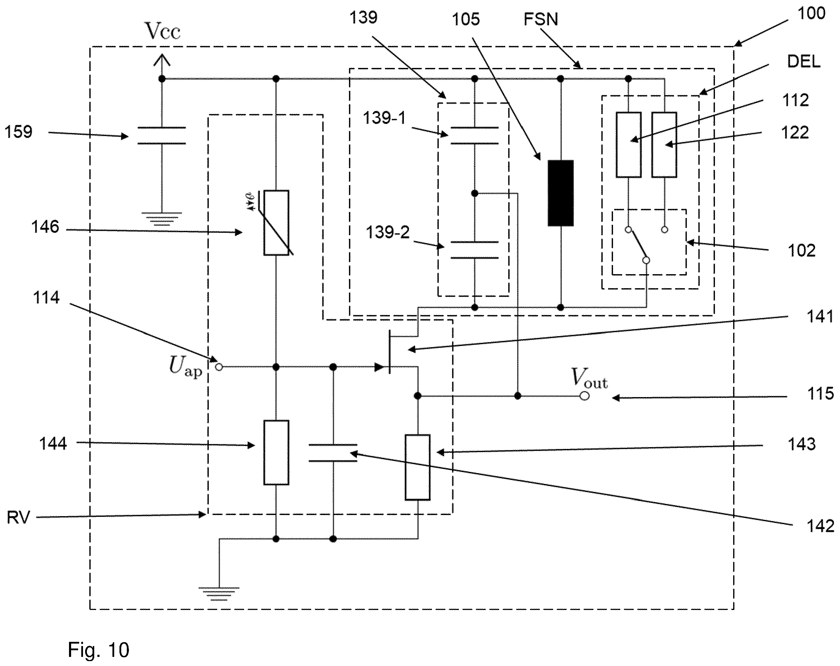

In Fig. 10 ist ein detaillierteres Schaltbild einer beispielhaften Ausführungsform der erfindungsgemäßen Oszillatorschaltung mit Temperaturkompensation dargestellt. Gleiche Bezugszahlen bezeichnen die gleichen Komponenten wie in den vorhergehenden Figuren. Der Verstärker RV wird hier durch einen Sperrschicht-Feldeffekt-Transistor (JFET) 141 in Gateschaltung, den Widerständen 144, 146 und 143 und dem Kondensator 142 gebildet, mit deren Hilfe der Arbeitspunkt des Transistors 141 eingestellt wird. Das frequenzselektive Netzwerk FSN besteht aus der Induktivität 105, dem kapazitiven Element 139, gebildet aus den Kapazitäten 139-1 und 139-2 und dem Dämpfungselement DEL, bestehend aus den wirksamen Widerständen 112, 122 und dem zu überwachenden Kontakt 101, dessen Zustand die Wirkung des einen oder des anderen Dämpfungswiderstandes 112, 122 bestimmt. Der Kondensator 159 stabilisiert die Betriebsspannung. Die Schaltung kann so ausgelegt werden, dass für eine erste wirksame Dämpfung über den Dämpfungswiderstand 112 am Ausgang 115 ein oszillierendes Signal beobachtet werden kann und bei einer wirksamen Dämpfung über den Dämpfungswiderstand 122 dieses oszillierende Signal nicht vorhanden ist.

Erfindungsgemäß wird der Arbeitspunkt des Transistors 141 durch einen Spannungsteiler bestehend aus einem Thermistor 146 und dem Widerstand 144 so beeinflusst, dass die Verstärkung des Transistors 141 (nahezu) unabhängig von der Temperatur ist oder vernachlässigt werden kann. Als Thermistor kann ein temperaturabhängiger Widerstand eingesetzt werden. Es gibt den sogenannten Kaltleiter. Das ist z.B. ein PTC-Widerstand (englisch: Positive Temperature Coefficient Resistor), dessen Widerstandswert mit steigender Temperatur zunimmt. Daneben gibt es den sogenannten Heißleiter, NTC-Widerstand (englisch: Negative Temperature Coefficient Resistor), dessen Widerstandswert bei steigender Temperatur abnimmt. Darüber hinaus können als Heißleiter auch andere Bauteile mit einem temperaturabhängigen Verhalten, wie z.B. Halbleiterdioden, in Sperrrichtung verwendet werden (nicht dargestellt).

Die Arbeitspunktspannung $U_{ap}$ ergibt sich aus der Versorgungsspannung Vcc und dem temperaturabhängigen Teilerverhältnis der Widerstände 146 und 144. Die Arbeitspunktspannung $U_{ap}$, ergibt sich nach der folgenden Formel:

$$U_{ap} = V_{cc} * R144 / (R146(\vartheta)+R144).$$

Dabei betrifft $U_{ap}$ die Arbeitspunktspannung am Punkt 114, Vcc die Versorgungsspannung und $\vartheta$ die Temperatur.

Durch eine geeignete Auslegung der Widerstände 144 und 146 steigt (oder fällt) die Arbeitspunktspannung mit der Temperatur gerade so stark, dass sich die Einflüsse der temperaturabhängigen Verstärkung mit der arbeitspunktabhängigen Verstärkung möglichst gut kompensieren. Mit anderen Worten wird am Gate des Transistors 141 eine temperaturabhängige Vorspannung gerade so angelegt, dass der Verstärkungsfaktor V möglichst unabhängig von der Temperatur ist. Dadurch kann eine weitgehend temperaturunabhängige Verstärkung, und somit eine temperaturunabhängige Schwinggrenze, erreicht werden. Der Kondensator 142 ist optional und kann beispielsweise dazu genutzt werden, um die Arbeitspunktspannung zu glätten. Die optimale Kombination der Widerstände 144, 146 und des Kondensators 142 kann beispielsweise experimentell ermittelt werden.

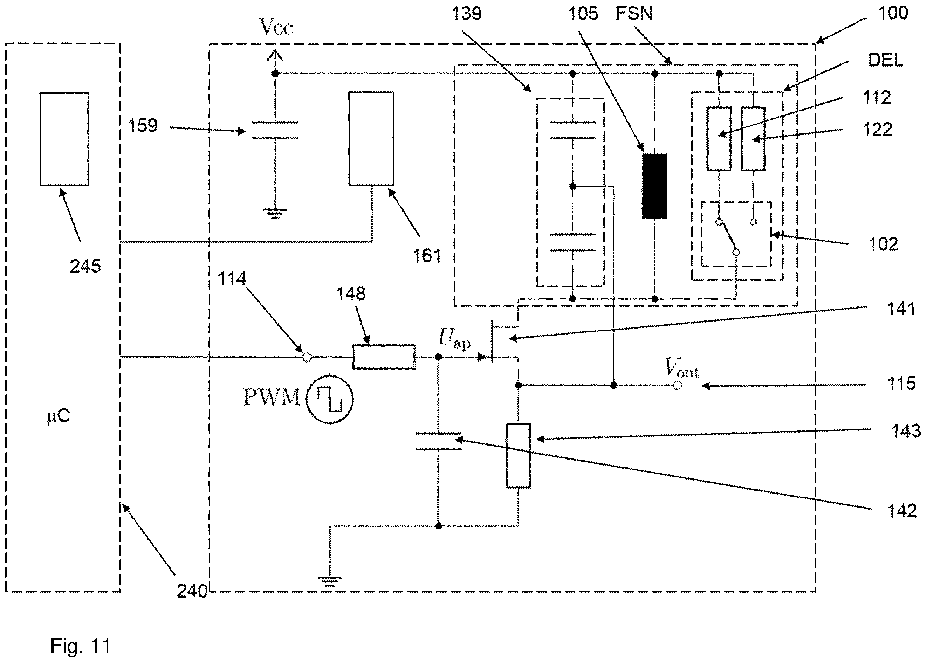

Die Fig. 11 zeigt eine andere Art der Temperaturkompensation. Auch bei dieser Variante wird der Arbeitspunkt des Transistors 141 stabilisiert. Diese Lösung entspricht einer digitalen Umsetzung der Arbeitspunktstabilisierung. Dabei wird die Arbeitspunktspannung $U_{ap}$ digital erzeugt und direkt temperaturkompensiert bereitgestellt. Dafür ist es erforderlich, die Temperatur $\vartheta$ zu messen. Es wird also ein Temperatursensor benötigt. Dieser ist in Fig. 11 mit Bezugszahl 161 bezeichnet. Mit der Bezugszahl 200 ist ein Mikrocontroller bezeichnet. Daran ist der Temperatursensor 161 angeschlossen. In dem Mikrocontroller 200 ist eine Temperatur-Arbeitspunkttabelle 245 abgespeichert. Der gemessene Temperaturwert indiziert die Temperatur-Arbeitspunkttabelle 245. Aus der Temperatur-Arbeitspunkttabelle 245 wird die Information für ein zugeordnetes pulsweitenmoduliertes Signal entnommen. Der Mikrocontroller 200 generiert das zugeordnete pulsweitenmodulierte Signal und gibt es über einen seiner Mehrzweck-Ausgänge GPIO (General Purpose Input/Output) aus. Es wird am Punkt 114 bei der Kontaktüberwachungsvorrichtung 100 eingespeist. Die Pulsweite des Signales wird temperaturabhängig moduliert. Damit daraus die temperaturkompensierte Arbeitspunktspannung $U_{ap}$ entsteht, muss der Puls/Pausen-abhängige Mittelwert des Signals gebildet werden. Dies geschieht bei der in Fig. 11 gezeigten Schaltung mit dem Widerstand 148 und dem Kondensator 142, die zusammen ein Tiefpassfilter bilden. Das Tiefpassfilter ist zwischen Einspeisepunkt 114 und Transistor 141 geschaltet.

Mit dieser Lösung können außer der Temperatur auch noch andere Effekte wie Alterung, Bauteiltoleranzen, Schwankungen in der Versorgungsspannung etc. kompensiert werden. Diese Lösung kann auch zum Abgleich des hergestellten Produktes nach dem Fertigungsprozess eingesetzt werden. Die Bauteiltoleranzen und Fertigungsabweichungen machen gegebenenfalls einen Produktabgleich erforderlich.

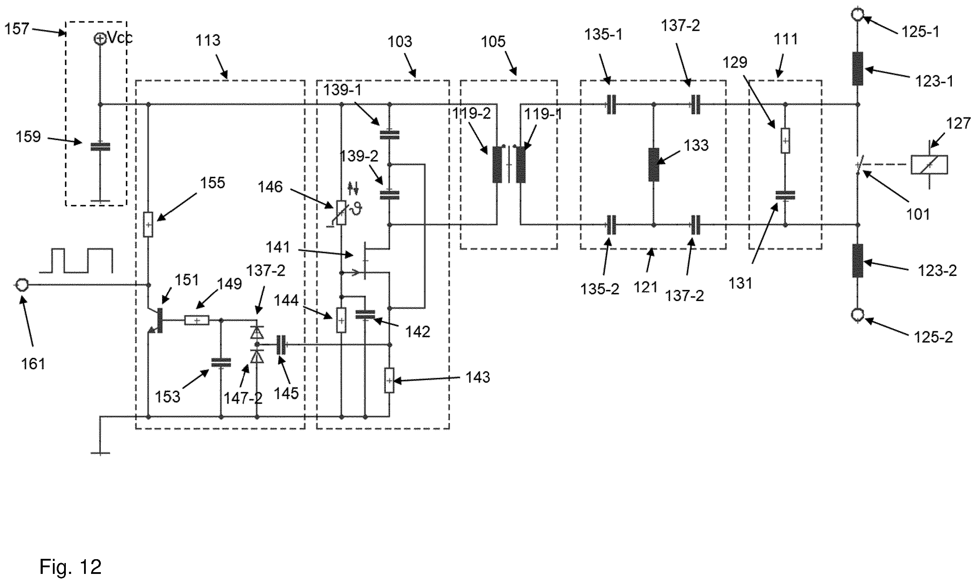

In Fig. 12 ist das Schaltbild der Temperaturkompensationsschaltung zusammen mit dem in dem Ausführungsbeispiel von Fig. 1 gezeigten Schaltbild dargestellt, bei dem die Temperaturkompensation mit Heißleiter 146 eingesetzt ist. Der temperaturabhängige Spannungsteiler bestehend aus NTC Widerstand 146 und Widerstand 144 stellt mit $U_{ap} = V_{cc} *$ R144 / (R146($\vartheta$)+R144) die Gatespannung zur Verfügung, die mit Hilfe des Kondensators 142 geglättet wird. Die temperaturabhängige Gatespannung sorgt durch eine geeignete Dimensionierung der Bauteile dafür, dass die Verstärkung des Transistors 141 möglichst temperaturunabhängig ist.

Es sollte verstanden werden, dass das vorgeschlagene Verfahren und die zugehörigen Vorrichtungen in verschiedenen Formen von Hardware, Software, Firmware, Spezialprozessoren oder einer Kombination davon implementiert werden können. In einer bevorzugten Variante werden Mikrocontroller mit integriertem RAM-Speicher und integrierten I/O-Schnittstellen eingesetzt. Spezialprozessoren können anwendungsspezifische integrierte Schaltungen (ASICs), Reduced Instruction Set Computer (RISC) und / oder Field Programmable Gate Arrays (FPGAs) umfassen. Vorzugsweise wird das vorgeschlagene Verfahren und die Vorrichtung als eine Kombination von Hardware und Software implementiert. Die Software wird vorzugsweise als ein Anwendungsprogramm auf einer Programmspeichervorrichtung installiert. Typischerweise handelt es sich um eine Maschine auf Basis einer Computerplattform, die Hardware aufweist, wie beispielsweise eine oder mehrere Zentraleinheiten (CPU), einen Direktzugriffsspeicher (RAM) und eine oder mehrere Eingabe/Ausgabe (I/O) Schnittstelle(n). Auf der Computerplattform wird typischerweise außerdem ein Betriebssystem installiert. Die verschiedenen Prozesse und Funktionen, die hier beschrieben wurden, können Teil des Anwendungsprogramms sein oder ein Teil, der über das Betriebssystem ausgeführt wird.

Bezugszeichenliste

| | |
|---|---|
| 100 | Kontaktüberwachungsvorrichtung |
| 101 | Elektrischer Kontakt |
| 102 | Schaltkontakt |
| 103 | Oszillatorschaltkreis |
| 105 | Koppelelement |
| 107 | Signaleingang |
| 109 | Signalausgang |
| 111 | Dämpfungselement |
| 112 | Erster wirksamer Widerstand |
| 113 | Detektor |
| 114 | Einspeisepunkt |
| 115 | Detektorausgang |
| 117 | Transformator |
| 119-1 | Erste Induktivität |
| 119-2 | Zweite Induktivität |
| 121 | Impedanzschaltung |
| 122 | Zweiter wirksamer Widerstand |
| 123-1 | Erstes Filterelement |
| 123-2 | Zweites Filterelement |
| 125-1 | Erster Ausgangsanschluss |
| 125-2 | Zweiter Ausgangsanschluss |
| 127 | Schaltelement |
| 129 | Widerstand |
| 131 | Kapazität |
| 133 | Induktivität |
| 135-1 | Kapazität |
| 135-2 | Kapazität |
| 137-1 | Kapazität |
| 137-2 | Kapazität |
| 139 | Kapazitives Element |
| 139-1 | Kapazität |
| 139-2 | Kapazität |
| 141 | Transistor |
| 142 | Kondensator |
| 143 | Widerstand |
| 144 | Widerstand |
| 145 | Kapazität |
| 146 | Heißleiter |
| 147-1 | Diode |
| 147-2 | Diode |
| 149 | Widerstand |
| 151 | Transistor |
| 153 | Kapazität |

| | |
|---|---|
| 155 | Pull-Up Widerstand |
| 157 | Versorgungsspannungsanschluss |
| 159 | Glättungskondensator |
| 161 | Ausgabesignalanschluss |
| | |
| 201 | Schaltmodul |
| 203 | Schaltmodulsockel |
| 205-1 | Schaltkontaktanschluss |
| 205-2 | Schaltkontaktanschluss |
| 205-3 | Schaltkontaktanschluss |
| 207-1 | Steckkontakt |
| 207-2 | Steckkontakt |
| 207-3 | Steckkontakt |
| 209 | Durchgangsanschluss |
| 211 | Filtermodul |
| 213 | Gleichrichter |
| 215-1 | Erster Schaltsteueranschluss |
| 215-2 | Zweiter Schaltsteueranschluss |
| 217-1 | Erster Schaltsignalausgang |
| 217-2 | Zweiter Schaltsignalausgang |
| 219-1 | Erster Schaltanschlussstecker |
| 219-2 | Zweiter Schaltanschlussstecker |
| 221-1 | Erster Lastanschluss |
| 221-2 | Zweiter Lastanschluss |
| 223 | Lastspannungsversorgung |
| 225 | Elektrische Last |
| 227 | Leitungsbrücke |
| 229 | Trennlinie |
| 240 | Mikrocontroller |
| 245 | Temperatur-Arbeitspunkttabelle |
| | |
| 301 | Widerstandsgrenzwert |
| 303 | Erste Impedanzkurve |
| 303a | Erster Resonanzfrequenzpunkt |
| 305 | Zweite Impedanzkurve |
| 305a | Zweiter Resonanzfrequenzpunkt |
| | |
| 401 | Ferrit |
| 611 | Dämpfungselement |
| 601 | Induktivität |
| 603 | Kapazität |
| | |
| DEL | Dämpfungselement |
| FSN | frequenzselektives Netzwerk |
| RV | Resonanzverstärker |

**Patentansprüche**

1. Kontaktüberwachungsvorrichtung (100) zur Überwachung eines elektrischen Kontakts (101) mit einem ersten Kontaktzustand und einem zweiten Kontaktzustand, wobei die Kontaktüberwachungsvorrichtung (100) die folgenden Merkmale aufweist:

   einen Oszillatorschaltkreis (103), welcher ausgebildet ist, ein Anregungssignal zu erzeugen,
   ein Koppelelement (105) mit einem Signaleingang (107) und einem Signalausgang (109), wobei der Oszillatorschaltkreis (103) dem Signaleingang (107) vorgeschaltet ist, um das Koppelelement (105) mit dem Anregungssignal zu beaufschlagen, wobei das Koppelelement (105) ausgebildet ist, das Anregungssignal in ein Kontaktüberwachungssignal zu überführen und das Kontaktüberwachungssignal an dem Signalausgang (109) zum Beaufschlagen des elektrischen Kontakts (101) auszugeben, wobei mit dem elektrischen Kontakt (101) in dem ersten Kontaktzustand an dem Oszillatorschaltkreis (103) ein erster Impedanzwert eingestellt ist, und mit dem elektrischen Kontakt (101) in dem zweiten Kontaktzustand an dem Oszillatorschaltkreis (103) ein zweiter Impedanzwert eingestellt ist, und einen Detektor (113), welcher ausgebildet ist, eine Version des Anregungssignals zu erfassen, um den elektrischen Kontakt (101) zu überwachen,

**dadurch gekennzeichnet, dass**

der Oszillatorschaltkreis (103) ausgebildet ist, mit dem elektrischen Kontakt (101) in dem ersten Kontaktzustand und dem ersten Impedanzwert eine Resonanzschwingung zu erzeugen und das Anregungssignal auszugeben, wobei der Oszillatorschaltkreis (103) ein Mittel aufweist zur thermischen Stabilisierung des Oszillatorschaltkreises (103),

wobei der Oszillatorschaltkreis (103) einen Schwingkreis mit einem Rückkopplungszweig aufweist und einen Verstärker (RV), wobei der Verstärker (RV) das über den Rückkopplungszweig rückgekoppelte Signal verstärkt, wobei der Verstärker (RV) wenigstens einen Transistor (141) aufweist, dessen Arbeitspunkt einstellbar ist, wobei die Verstärkung des wenigstens einen Transistors (141) mit dem Mittel zur thermischen Stabilisierung durch Anpassung des Arbeitspunktes stabilisiert ist.

2.  Kontaktüberwachungsvorrichtung (100) nach Anspruch 1, wobei die Kontaktüberwachungsvorrichtung (100) ausgebildet ist, in dem zweiten Kontaktzustand die Ausbildung der Resonanzschwingung und damit die Erzeugung des Anregungssignals entweder zu unterbinden oder eine andere Resonanzschwingung zu erzeugen und ein anderes Anregungssignal auszugeben, und wobei der Detektor (113) ausgebildet ist, eine Version des ersten Anregungssignals und eine Version des anderen Anregungssignals oder eine Version des ersten Anregungssignals und das Ausbleiben des ersten Anregungssignal zu erfassen, um den elektrischen Kontaktzustand zu erfassen.

3.  Kontaktüberwachungsvorrichtung (100) nach Anspruch 1 oder 2, wobei der Arbeitspunkt des Transistors (141) über einen Spannungsteiler einstellbar ist, wobei als Mittel zur thermischen Stabilisierung ein Thermistor (146), insbesondere NTC- oder PTC-Widerstand, oder ein anderer Heißleiter oder Kaltleiter als ein Element des Spannungsteilers eingesetzt wird.

4.  Kontaktüberwachungsvorrichtung (100) nach einem der Ansprüche 1 bis 3, wobei als Mittel zur thermischen Stabilisierung ein Temperatursensor (161) eingesetzt wird, dessen Signal von einem Mikrocontroller (240) ausgewertet wird, der ein zugehöriges Korrektursignal erzeugt, das den Arbeitspunkt des wenigstens einen Transistors (141) zur thermischen Stabilisierung einstellt.

5.  Kontaktüberwachungsvorrichtung (100) nach Anspruch 4, wobei der Mikrocontroller (240) das Korrektursignal in Form eines PWM-Signals, entsprechend pulsweiten-moduliertes Signal, erzeugt, und ein Mittelwertbilder das PWM-Signal mittelt und dem Transistor (141) zuführt, optional wobei der Mittelwertbilder in Form eines Tiefpassfilters bestehend aus Widerstand (148) und Kondensator (142) ausgebildet ist.

6.  Kontaktüberwachungsvorrichtung (100) nach einem der vorstehenden Ansprüche, wobei der Oszillatorschaltkreis (103) ausgebildet ist, mit dem ersten Impedanzwert das Anregungssignal mit einer Anregungsfrequenz, welcher einer Resonanzfrequenz des Oszillatorschaltkreises (103) entspricht, zu erzeugen, und wobei der Oszillatorschaltkreis (103) ferner ausgebildet ist, eine Signalamplitude des Anregungssignals auf Basis eines Impedanzwertes an dem Signaleingang (107) zu ändern.

7.  Kontaktüberwachungsvorrichtung (100) nach einem der vorstehenden Ansprüche, mit einem Dämpfungselement (111, 611), welches dem Signalausgang (109) nachgeschaltet und mit dem elektrischen Kontakt (101) gekoppelt ist, wobei das Dämpfungselement (111, 611) ausgebildet ist, mit dem elektrischen Kontakt (101) in dem zweiten Kontaktzustand eine Impedanz bereitzustellen, um ein Wirken einer Impedanz des elektrischen Kontakts (101) in dem zweiten Kontaktzustand zu unterbinden, wobei mit dem Wirken des Dämpfungselements (111, 611) der Signaleingang (107) des Koppelelements (105) gedämpft ist, der Oszillatorschaltkreis (103) nicht schwingungsfähig ist und eine Ausgabe des Anregungssignals unterbunden ist.

8.  Kontaktüberwachungsvorrichtung (100) nach Anspruch 7, wobei das Koppelelement (105) und der Oszillatorschaltkreis (103) ausgebildet sind, einen Schwingkreis zu bilden, und wobei das Dämpfungselement (111) ausgebildet ist, den Schwingkreis in dem zweiten Kontaktzustand zu dämpfen, um eine Signalamplitude des Anregungssignals zu reduzieren, und/oder

wobei mit dem elektrischen Kontakt (101) in dem ersten Kontaktzustand das Dämpfungselement (111, 611) niederohmig überbrückt ist und eine mittels des Kopplungselements an den Signaleingang (107) gekoppelte Dämpfung des Dämpfungselements (111, 611) reduziert ist, und wobei der Oszillatorschaltkreis (103) ausgebildet ist, mit der reduzierten Dämpfung das Anregungssignal mit einer erhöhten Signalamplitude zu erzeugen, und/oder

wobei das Dämpfungselement (111, 611) eine Kapazität umfasst, welche durch einen Leiterplattenkondensator gebildet ist, und/oder

ferner umfassend eine Impedanzschaltung (121), welche dem Signalausgang (109) nachgeschaltet und mit dem Dämpfungselement (111, 611) gekoppelt ist, wobei die Impedanzschaltung (121) ausgebildet ist, eine Streuinduktivität und/oder eine Streukapazität des Koppelelements (105) bei einem Kontaktüberwachungssignal mit einer vorbestimmten Frequenz zu kompensieren , optional wobei die Impedanzschaltung (121) ausgebildet ist, eine Gesamtkapazität und/oder eine Gesamtinduktivität über der galvanischen Trennung des Koppelelements (105) zu reduzieren.

9. Kontaktüberwachungsvorrichtung (100) nach einem der vorstehenden Ansprüche, wobei der Oszillatorschaltkreis (103) einen Detektorausgang (115) aufweist und ausgebildet ist, über den Detektorausgang (115) dem Detektor (113) das Anregungssignal bereitzustellen.

10. Kontaktüberwachungsvorrichtung (100) nach einem der vorstehenden Ansprüche, wobei der Detektor (113) ausgebildet ist, das Anregungssignal in ein Ausgabesignal zu wandeln und das Ausgabesignal in mindestens zwei unterschiedlichen Signalzuständen auszugeben, wobei ein erster Signalzustand der mindestens zwei Signalzustände einen geschlossenen elektrischen Kontakt (101) anzeigt und ein zweiter Signalzustand der mindestens zwei Signalzustände einen offenen elektrischen Kontakt (101) anzeigt,
optional wobei der Detektor (113) ausgebildet ist, das Ausgabesignal in dem ersten Signalzustand auszugeben, wenn an dem Detektorausgang (115) ein oszillierendes Anregungssignal anliegt und das Ausgabesignal in dem zweiten Signalzustand auszugeben, wenn an dem Detektorausgang (115) ein nicht-oszillierendes Anregungssignal anliegt oder eine Signalamplitude des Anregungssignals unterhalb eines Amplitudengrenzwerts liegt.

11. Kontaktüberwachungsvorrichtung (100) nach einem der vorstehenden Ansprüche, wobei das Koppelelement (105) ausgebildet ist, den Oszillatorschaltkreis (103) und/oder den Detektor (113) von dem elektrischen Kontakt (101) galvanisch zu trennen.

12. Kontaktüberwachungsvorrichtung (100) nach einem der vorstehenden Ansprüche, wobei der Detektor (113) ausgebildet ist, ein Anschaltsignal zum Schalten des elektrischen Kontakts (101) und eine Änderung des Anregungssignals zu erfassen und wobei der Detektor (113) ferner ausgebildet ist ein binäres Fehlersignal auszugeben, welches anzeigt, ob der elektrische Kontakt (101) entsprechend dem Anschaltsignal geschaltet ist,

optional wobei der Detektor (113) ausgebildet ist, mit dem Empfangen des Anschaltsignals das Anregungssignal innerhalb eines vorbestimmten Zeitintervalls zu erfassen, um festzustellen, ob der elektrische Kontakt (101) entsprechend dem Anschaltsignal innerhalb des vorbestimmten Zeitintervalls geschaltet ist, und/oder
ferner aufweisend ein optisches Anzeigeelement, welches ausgebildet ist, das Erfassen des Anschaltsignals und ein entsprechendes erfasstes Schalten des elektrischen Kontakts (101) respektive eine Abweichung von dem erwarteten Anschaltsignal anzuzeigen.

13. Kontaktüberwachungsvorrichtung (100) nach einem der vorstehenden Ansprüche, wobei das Koppelelement (105) einen Transformator (117) umfasst, welcher eine erste Induktivität (119-1) und eine zweite Induktivität (119-2) aufweist, wobei die erste Induktivität (119-1) mit der zweiten Induktivität (119-2) induktiv gekoppelt ist, um das Anregungssignal in das Kontaktüberwachungssignal zu überführen.

14. Kontaktüberwachungsvorrichtung (100) nach einem der vorstehenden Ansprüche, mit einem ersten Filterelement (123-1) und einem zweiten Filterelement (123-2), wobei der elektrische Kontakt (101) einen ersten Ausgangsanschluss (125-1) aufweist, welchem das erste Filterelement (123-1) nachgeschaltet ist, und wobei der elektrische Kontakt (101) einen zweiten Ausgangsanschluss (125-2) aufweist, welchem das zweite Filterelement (123-2) nachgeschaltet ist, um hochfrequente Signale zu dämpfen, welche mittels des Koppelelements (105) an dem Schaltkontakt (101) und/oder an einer an den elektrischen Kontakt (101) gekoppelten elektrischen Last und/oder Spannungsquelle anliegen.

15. Kontaktüberwachungsvorrichtung (100) nach Anspruch 14, wobei das erste Filterelement (123-1) und/oder das zweite Filterelement (123-2) einen ohmschen Impedanzanteil bei der Oszillatorfrequenz aufweisen, welcher ausgebildet ist, ein Erfassen eines externen Kurzschlusses des ersten Ausgangsanschlusses (125-1) mit dem zweiten Ausgangsanschluss (125-2) als ein Schließen des elektrischen Kontakts (101) zu unterbinden.

**Claims**

1. A contact monitoring device (100) for monitoring an electrical contact (101) with a first contact state and a second contact state, wherein the contact monitoring device (100) has the following features:

   an oscillator circuit (103) which is configured to generate an excitation signal,
   a coupler (105) with a signal input (107) and a signal output (109), wherein the oscillator circuit (103) is connected upstream of the signal input (107) in order to apply the excitation signal to the coupler (105), wherein the coupler (105) is configured to convert the excitation signal into a contact monitoring signal and to output the contact monitoring signal at the signal output (109) for applying the electrical contact (101), wherein with the electrical contact (101) in the first contact state, a first impedance value is set on the oscillator circuit (103), and with the electrical contact (101) in the second contact state, a second impedance value is set on the oscillator circuit (103), and
   a detector (113) which is configured to detect a version of the excitation signal in order to monitor the electrical contact,
   **characterized in that**
   the oscillator circuit (103) is configured to generate a resonant oscillation with the electrical contact (101) in the first contact state and the first impedance value and to output the excitation signal,
   wherein the oscillator circuit (103) has a means for thermally stabilizing the oscillator circuit (103),
   wherein the oscillator circuit (103) has an oscillating circuit with a feedback branch and an amplifier (RV), where the amplifier (RV) amplifies the signal fed back via the feedback branch, where the amplifier (RV) has at least one transistor (141) whose operating point is adjustable, where the amplification of the at least one transistor (141) is stabilized by the means for thermal stabilization by adjusting the operating point.

2. The contact monitoring device (100) according to claim 1, wherein the contact monitoring device (100) is configured to either prevent the formation of the resonance oscillation and thus the generation of the excitation signal in the second contact state or to generate another resonance oscillation and output another excitation signal, and wherein the detector (113) is configured to detect a version of the first excitation signal and a version of the other excitation signal or a version of the first excitation signal and the absence of the first excitation signal in order to detect the electrical contact state.

3. The contact monitoring device (100) according to claim 1 or 2, wherein the operating point of the transistor (141) can be adjusted via a voltage divider, wherein a thermistor (146), in particular an NTC or PTC resistor, or another hot conductor or cold conductor is used as an element of the voltage divider as a means for thermal stabilization.

4. The contact monitoring device (100) according to one of claims 1 to 3, wherein a temperature sensor (161) is used as a means for thermal stabilization, the signal of which is evaluated by a microcontroller (240) which generates an associated correction signal which sets the operating point of the at least one transistor (141) for thermal stabilization.

5. The contact monitoring device (100) according to claim 4, wherein the microcontroller (240) generates the correction signal in the form of a PWM signal, corresponding to a pulse width modulated signal, and an averager averages the PWM signal and supplies it to the transistor (141),
   optionally wherein the averager is designed in the form of a low-pass filter consisting of a resistor (148) and a capacitor (142).

6. The contact monitoring device (100) according to one of the preceding claims, wherein the oscillator circuit (103) is configured to generate the excitation signal with the first impedance value at an excitation frequency which corresponds to a resonance frequency of the oscillator circuit (103), and wherein the oscillator circuit (103) is further configured to change a signal amplitude of the excitation signal based on an impedance value at the signal input (107).

7. The contact monitoring device (100) according to one of the preceding claims, with a attenuator (111, 611) which is connected downstream of the signal output (109) and coupled to the electrical contact (101), wherein the attenuator (111, 611) is configured to provide an impedance with the electrical contact (101) in the second contact state in order to prevent an impedance of the electrical contact (101) from acting in the second contact state, wherein the signal input (107) of the coupler (105) is dampened with the action of the attenuator (111, 611), the oscillator circuit (103) is not capable of oscillation and an output of the excitation signal is prevented.

8. The contact monitoring device (100) according to claim 7, wherein the coupler (105) and the oscillator circuit (103) are configured to form an oscillating circuit, and wherein the attenuator (111) is configured to dampen the oscillating circuit in the second contact state in order to reduce a signal amplitude of the excitation signal, and/or

   wherein the electrical contact (101) in the first contact state bridges the attenuator (111, 611) with low resistance and a damping of the attenuator (111, 611) coupled to the signal input (107) by means of the coupler is reduced, and wherein the oscillator circuit (103) is configured to generate the excitation signal with an increased signal amplitude with the reduced damping, and/or
   wherein the attenuator (111, 611) comprises a capacitance which is formed by a circuit board capacitor, and/or further comprising an impedance circuit (121) which is connected downstream of the signal output (109) and coupled to the attenuator (111, 611), wherein the impedance circuit (121) is configured to compensate for a stray inductance and/or a stray capacitance of the coupler (105) in the case of a contact monitoring signal with a predetermined frequency, optionally wherein the impedance circuit (121) is configured to reduce a total capacitance and/or a total inductance across the galvanic isolation of the coupler (105).

9. The contact monitoring device (100) according to one of the preceding claims, wherein the oscillator circuit (103) has a detector output (115) and is configured to provide the excitation signal to the detector (113) via the detector output (115).

10. The contact monitoring device (100) according to one of the preceding claims, wherein the detector (113) is configured to convert the excitation signal into an output signal and to output the output signal in at least two different signal states, wherein a first signal state of the at least two signal states indicates a closed electrical contact (101) and a second signal state of the at least two signal states indicates an open electrical contact (101), optionally wherein the detector (113) is configured to output the output signal in the first signal state when an oscillating excitation signal is present at the detector output (115) and to output the output signal in the second signal state when a non-oscillating excitation signal is present at the detector output (115) or a signal amplitude of the excitation signal is below an amplitude limit value.

11. The contact monitoring device (100) according to one of the preceding claims, wherein the coupler (105) is configured to galvanicaly isolate the oscillator circuit (103) and/or the detector (113) from the electrical contact (101).

12. The contact monitoring device (100) according to one of the preceding claims,

   wherein the detector (113) is configured to detect a switch-on signal for switching the electrical contact (101) and a change in the excitation signal, and wherein the detector (113) is further configured to output a binary error signal which indicates whether the electrical contact (101) is switched in accordance with the switch-on signal, optionally wherein the detector (113) is configured to detect the excitation signal within a predetermined time interval when receiving the switch-on signal in order to determine whether the electrical contact (101) is switched in accordance with the switch-on signal within the predetermined time interval, and/or
   further comprising an optical display element which is configured to display the detection of the switch-on signal and a corresponding detected switching of the electrical contact (101) or a deviation from the expected switch-on signal.

13. The contact monitoring device (100) according to one of the preceding claims, wherein the coupler (105) comprises a transformer (117) having a first inductance (119-1) and a second inductance (119-2), wherein the first inductance (119-1) is inductively coupled to the second inductance (119-2) in order to convert the excitation signal into the contact monitoring signal.

14. The contact monitoring device (100) according to one of the preceding claims, with a first filter element (123-1) and a second filter element (123-2), wherein the electrical contact (101) has a first output connection (125-1), which is followed by the first filter element (123-1), and wherein the electrical contact (101) has a second output connection (125-2), which is followed by the second filter element (123-2) in order to attenuate high-frequency signals which are present at the switching contact (101) and/or at an electrical load and/or voltage source coupled to the electrical contact (101) by means of the coupler (105).

**15.** The contact monitoring device (100) according to claim 14, wherein the first filter element (123-1) and/or the second filter element (123-2) have an ohmic impedance component at the oscillator frequency, which is configured to prevent detection of an external short circuit of the first output terminal (125-1) with the second output terminal (125-2) as a closing of the electrical contact (101).

**Revendications**

**1.** Dispositif de surveillance de contact (100) pour surveiller un contact électrique (101) ayant un premier état de contact et un deuxième état de contact, le dispositif de surveillance de contact (100) comprenant les caractéristiques suivantes:

un circuit oscillateur (103) qui est conçu pour générer un signal d'excitation, un élément de couplage (105) avec une entrée de signal (107) et une sortie de signal (109), le circuit oscillateur (103) étant connecté en amont de l'entrée de signal (107) pour appliquer le signal d'excitation à l'élément de couplage (105), l'élément de couplage (105) est conçu pour convertir le signal d'excitation en un signal de surveillance de contact et pour émettre le signal de surveillance de contact à la sortie de signal (109) pour agir sur le contact électrique (101), le contact électrique (101) dans le premier état de contact sur le circuit oscillateur (103) ayant une première valeur d'impédance est définie, et avec le contact électrique (101) dans le deuxième état de contact sur le circuit oscillateur (103), une deuxième valeur d'impédance est définie, et un détecteur (113) conçu pour détecter une version du signal d'excitation afin de surveiller le contact électrique (101), **caractérisé en ce que** le circuit oscillateur (103) est conçu pour générer une oscillation de résonance avec le contact électrique (101) dans le premier état de contact et la première valeur d'impédance et pour délivrer le signal d'excitation, dans lequel le circuit oscillateur (103) comporte un moyen pour stabiliser thermiquement le circuit oscillateur (103), dans lequel le circuit oscillateur (103) comporte un circuit résonant avec une branche de rétroaction et un amplificateur (RV), dans lequel l'amplificateur (RV) amplifie le signal renvoyé via la branche de rétroaction, l'amplificateur (RV) comportant au moins un transistor (141), dont le point de fonctionnement est réglable, le gain du ou des transistors (141) étant stabilisé à l'aide des moyens de stabilisation thermique en ajustant le point de fonctionnement.

**2.** Dispositif de surveillance de contact (100) selon la revendication 1, le dispositif de surveillance de contact (100) étant conçu, dans le deuxième état de contact, soit pour empêcher la formation de l'oscillation de résonance et donc la production du signal d'excitation, soit pour produire une autre oscillation de résonance et émettre un autre signal d'excitation, et le détecteur (113) étant conçu pour détecter une version du premier signal d'excitation et une version de l'autre signal d'excitation ou une version du premier signal d'excitation et l'absence du premier signal d'excitation, afin de détecter l'état de contact électrique.

**3.** Dispositif de surveillance de contact (100) selon la revendication 1 ou 2, dans lequel le point de fonctionnement du transistor (141) est réglable par l'intermédiaire d'un diviseur de tension, dans lequel une thermistance (146), en particulier une résistance NTC ou PTC, ou une autre thermistance chaude ou froide est utilisée comme moyen de stabilisation thermique en tant qu'élément du diviseur de tension.

**4.** Dispositif de surveillance de contact (100) selon l'une des revendications 1 à 3, dans lequel on utilise comme moyen de stabilisation thermique un capteur de température (161) dont le signal est évalué par un microcontrôleur (240) qui génère un signal de correction associé qui règle le point de fonctionnement d'au moins un transistor (141) pour la stabilisation thermique.

**5.** Dispositif de surveillance de contact (100) selon la revendication 4, dans lequel le microcontrôleur (240) génère le signal de correction sous la forme d'un signal MLI, correspondant à un signal modulé en largeur d'impulsion, et un générateur de valeur moyenne fait la moyenne du signal MLI et l'applique au transistor (141), en option, l'imageur de valeur moyenne étant réalisé sous la forme d'un filtre passe-bas composé d'une résistance (148) et d'un condensateur (142).

**6.** Dispositif de surveillance de contact (100) selon l'une quelconque des revendications précédentes, dans lequel le circuit oscillateur (103) est adapté pour générer le signal d'excitation avec la première valeur d'impédance à une fréquence d'excitation correspondant à une fréquence de résonance du circuit oscillateur (103), et dans lequel le circuit oscillateur (103) est en outre adapté pour modifier une amplitude de signal du signal d'excitation sur la base d'une valeur d'impédance à l'entrée de signal (107).

7. Dispositif de surveillance de contact (100) selon l'une des revendications précédentes, comprenant un élément d'amortissement (111, 611) qui est monté en aval de la sortie de signal (109) et qui est couplé au contact électrique (101), l'élément d'amortissement (111, 611) étant conçu pour fournir une impédance avec le contact électrique (101) dans le deuxième état de contact, pour empêcher l'action d'une impédance du contact électrique (101) dans le deuxième état de contact, dans lequel, avec l'action de l'élément d'amortissement (111, 611), l'entrée de signal (107) de l'élément de couplage (105) est amortie, le circuit oscillateur (103) ne peut pas osciller et une sortie du signal d'excitation est empêchée.

8. Dispositif de surveillance de contact (100) selon la revendication 7, dans lequel l'élément de couplage (105) et le circuit oscillant (103) sont conçus pour former un circuit oscillant, et dans lequel l'élément d'amortissement (111) est conçu pour amortir le circuit oscillant dans le deuxième état de contact afin de réduire une amplitude de signal du signal d'excitation, et/ou

l'élément d'amortissement (111, 611) étant ponté à basse impédance avec le contact électrique (101) dans le premier état de contact et un amortissement de l'élément d'amortissement (111, 611) couplé à l'entrée de signal (107) au moyen de l'élément de couplage étant réduit, et le circuit d'oscillateur (103) étant conçu pour générer le signal d'excitation avec une amplitude de signal accrue avec l'amortissement réduit, et/ou
l'élément d'atténuation (111, 611) comprenant une capacité qui est formée par un condensateur de carte de circuit imprimé, et/ou
comprenant en outre un circuit d'impédance (121) qui est monté en aval de la sortie de signal (109) et qui est couplé à l'élément d'amortissement (111, 611), le circuit d'impédance (121) étant conçu pour compenser une inductance de fuite et/ou une capacité de fuite de l'élément de couplage (105) dans le cas d'un signal de surveillance de contact avec une fréquence prédéterminée, en option le circuit d'impédance (121) étant conçu pour réduire une capacité totale et/ou une inductance totale sur la séparation galvanique de l'élément de couplage (105).

9. Dispositif de surveillance de contact (100) selon l'une des revendications précédentes, dans lequel le circuit oscillateur (103) présente une sortie de détecteur (115) et est conçu pour fournir le signal d'excitation au détecteur (113) par l'intermédiaire de la sortie de détecteur (115).

10. Dispositif de surveillance de contact (100) selon l'une des revendications précédentes, dans lequel le détecteur (113) est adapté pour convertir le signal d'excitation en un signal de sortie et pour émettre le signal de sortie dans au moins deux états de signal différents, un premier état de signal des au moins deux états de signal indiquant un contact électrique fermé (101) et un deuxième état de signal des au moins deux états de signal indiquant un contact électrique ouvert (101),
en option, le détecteur (113) étant conçu pour émettre le signal de sortie dans le premier état de signal lorsqu'un signal d'excitation oscillant est présent à la sortie (115) du détecteur et pour émettre le signal de sortie dans le deuxième état de signal lorsqu'un signal d'excitation non oscillant est présent à la sortie (115) du détecteur ou lorsqu'une amplitude de signal du signal d'excitation est inférieure à une valeur limite d'amplitude.

11. Dispositif de surveillance de contact (100) selon l'une quelconque des revendications précédentes, dans lequel l'élément de couplage (105) est adapté pour isoler galvaniquement le circuit oscillateur (103) et/ou le détecteur (113) du contact électrique (101).

12. Dispositif de surveillance de contact (100) selon l'une quelconque des revendications précédentes, dans lequel le détecteur (113) est adapté pour détecter un signal de mise en marche pour commuter le contact électrique (101) et un changement du signal d'excitation, et dans lequel le détecteur (113) est en outre adapté pour émettre un signal d'erreur binaire indiquant si le contact électrique (101) est commuté conformément au signal de mise en marche,

en option, dans lequel le détecteur (113) est adapté pour détecter, avec la réception du signal d'activation, le signal d'excitation dans un intervalle de temps prédéterminé pour déterminer si le contact électrique (101) est commuté conformément au signal d'activation dans l'intervalle de temps prédéterminé, et/ou
comprenant en outre un élément d'affichage optique qui est conçu pour indiquer la détection du signal d'activation et une commutation détectée correspondante du contact électrique (101), respectivement un écart par rapport au signal d'activation attendu.

**13.** Dispositif de surveillance de contact (100) selon l'une quelconque des revendications précédentes, dans lequel l'élément de couplage (105) comprend un transformateur (117) qui présente une première inductance (119-1) et une deuxième inductance (119-2), la première inductance (119-1) étant couplée inductivement à la deuxième inductance (119-2) pour convertir le signal d'excitation en le signal de surveillance de contact.

**14.** Dispositif de surveillance de contact (100) selon l'une des revendications précédentes, comprenant un premier élément de filtrage (123-1) et un deuxième élément de filtrage (123-2), dans lequel le contact électrique (101) comprend une première borne de sortie (125-1) en aval de laquelle est connecté le premier élément de filtrage (123-1), et dans lequel le contact électrique (101) comporte une deuxième borne de sortie (125-2) en aval de laquelle est monté le deuxième élément de filtre (123-2), afin d'atténuer des signaux à haute fréquence qui sont appliqués au contact de commutation (101) et/ou à une charge électrique et/ou une source de tension couplée au contact électrique (101) au moyen de l'élément de couplage (105).

**15.** Dispositif de surveillance de contact (100) selon la revendication 14, dans lequel au moins l'un du premier élément de filtre (123-1) et du deuxième élément de filtre (123-2) comprend une partie d'impédance ohmique à la fréquence d'oscillateur qui est adaptée pour empêcher la détection d'un court-circuit externe de la première borne de sortie (125-1) avec la deuxième borne de sortie (125-2) en tant que fermeture du contact électrique (101).

Fig. 1

EP 4 058 816 B1

Fig. 2

Fig. 3

Fig. 4

Fig. 5

EP 4 058 816 B1

Fig. 6

Fig. 7

Fig. 8

EP 4 058 816 B1

Fig. 9

EP 4 058 816 B1

Fig. 10

EP 4 058 816 B1

Fig. 11

Fig. 12

EP 4 058 816 B1

**IN DER BESCHREIBUNG AUFGEFÜHRTE DOKUMENTE**

**In der Beschreibung aufgeführte Patentdokumente**

- DE 102009006970 A1
- DE 102018114425 A1
- JP 2012211855 A